(19) Europäisches Patentamt
European Patent Office
Office européen des brevets

(11) **EP 4 622 222 A1**

(12) **EUROPEAN PATENT APPLICATION**
published in accordance with Art. 153(4) EPC

(43) Date of publication:
**24.09.2025 Bulletin 2025/39**

(21) Application number: **22966293.7**

(22) Date of filing: **26.11.2022**

(51) International Patent Classification (IPC):
**H04L 67/12** (2022.01)    **G08G 1/01** (2006.01)
**H04N 7/15** (2006.01)

(52) Cooperative Patent Classification (CPC):
**G08G 1/01; H04L 67/12; H04N 7/15**

(86) International application number:
**PCT/CN2022/134525**

(87) International publication number:
**WO 2024/108607 (30.05.2024 Gazette 2024/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• XIE, Junwen
  Shenzhen, Guangdong 518129 (CN)
• MA, Mengyao
  Shenzhen, Guangdong 518129 (CN)
• YAN, Min
  Shenzhen, Guangdong 518129 (CN)

(74) Representative: **Gill Jennings & Every LLP
The Broadgate Tower
20 Primrose Street
London EC2A 2ES (GB)**

(54) **DATA COMPRESSION METHOD, COMMUNICATION APPARATUS, AND COMMUNICATION SYSTEM**

(57) This application provides a data compression method, a communication apparatus, and a communication system. The method includes: A terminal device determines compression information based on indication information and first data, where the indication information includes types of a plurality of first regions in target space, the target space is determined based on a space boundary, and the first data is data in the target space. The terminal device sends the compression information. The terminal device may compress the first data in the plurality of first regions to different degrees based on the indication information, and does not set a uniform compression degree for the first data in the entire target space. The targeted data compression method can improve effectiveness of compressing transmission data and improve communication efficiency.

```
┌─────────────────┐              ┌─────────────────┐
│ Terminal device │              │  Base station   │
└────────┬────────┘              └────────┬────────┘
         │                                │
┌────────┴──────────────┐                 │
│ S201: Determine        │                │
│ compression            │                │
│ information based on    │               │
│ indication             │                │
│ information and first   │               │
│ data, where            │                │
│ the indication          │               │
│ information            │                 │
│ includes types of a     │               │
│ plurality of           │                 │
│ first regions in        │               │
│ target space           │                 │
└────────┬──────────────┘                 │
         │                                │
         │ S202: Send the compression info│rmation
         │───────────────────────────────>│
         │                                │
```

FIG. 2

EP 4 622 222 A1

## Description

### TECHNICAL FIELD

This application relates to the field of communication technologies, and in particular, to a data compression method, a communication apparatus, and a communication system.

### BACKGROUND

Environment reconstruction is to establish a mathematical model suitable for computer representation and processing of an objective world environment, which is used to establish a virtual reality for representing the objective world in a computer. The environment reconstruction is applicable in various fields.

For example, in the field of autonomous driving, an obstacle avoidance problem of an autonomous driving vehicle in a driving process can be effectively resolved through the environment reconstruction. After obtaining data through scanning, a device uploads the data to a base station to restore an environment. However, how to coordinate data obtained by scanning sensors of a plurality of devices and improve communication efficiency between the devices needs to be urgently resolved.

### SUMMARY

Embodiments of this application disclose a data compression method, a communication apparatus, and a communication system, which are applicable to a scenario in which an environment needs to be reconstructed by using sensor data, and can improve communication efficiency between devices.

According to a first aspect, an embodiment of this application provides a data compression method. The method may be applied to a terminal device, or may be applied to an apparatus (for example, a chip, a chip system, or a circuit) in the terminal device, or may be an apparatus that can be used together with the terminal device. This is not limited herein. The following provides descriptions by using an example in which the method is applied to the terminal device. The method includes:

determining compression information based on indication information and first data, where the indication information includes types of a plurality of first regions in target space, the target space is determined based on a space boundary, and the first data is data in the target space; and sending the compression information.

In the solution provided in this application, the compression information is determined based on the indication information and the first data. The indication information includes the types of the plurality of first regions in the target space. The terminal device may compress first data in the plurality of first regions to different degrees based on the indication information (for example, the types of the plurality of first regions in the target space), and does not set a uniform compression degree for the first data in the entire target space. The targeted data compression method can improve effectiveness of compressing transmission data and improve communication efficiency.

In a possible implementation, the determining compression information based on indication information and first data includes:

determining a compression level, where the compression level is one of N compression levels, an $M^{th}$ compression level represents compressing first data in first regions of M types, the $M^{th}$ compression level is one of the N compression levels, N is a positive integer, and M is a positive integer not greater than N; and compressing target data in a plurality of target regions based on the compression level to obtain the compression information, where the plurality of target regions are the plurality of first regions in the target space.

In a possible implementation, the method further includes:

determining a compression mode, where the compression mode includes a subtree mode and a quantization mode; and the compressing target data in a plurality of target regions based on the compression level to obtain the compression information, where the plurality of target regions are the plurality of first regions in the target space includes: compressing the target data in the plurality of target regions based on the compression level and the compression mode to obtain the compression information, where the plurality of target regions are the plurality of first regions in the target space.

In the solution provided in this application, the compression level and the compression mode are set, and the compression level and/or the compression mode are/is not fixed. Instead, the compression level and/or the compression mode are/is first determined based on an actual situation, and then the target data is compressed based on the compression level and/or the compression mode to obtain the compression information. This can improve flexibility of data compression.

In a possible implementation, the plurality of target regions are regions that are in the plurality of first regions and that include the first data.

In a possible implementation, the indication information includes an indication mode, the indication mode indicates a manner of the types of the plurality of first regions, and the indication mode includes a grid mode and a space tree mode.

In a possible implementation, the types of the plurality of first regions in the target space are determined based on a data feature of second data in the plurality of first regions.

In a possible implementation, the indication mode is determined based on a data feature of the second data in the target space.

In the solution provided in this application, the types of the plurality of first regions in the target space are determined based on the data feature of the second data in the plurality of first regions, and a base station may indicate the terminal device to perform region-based compression, to balance communication resources and performance. However, determining the indication mode based on the data feature of the second data in the target space can reduce a quantity of bits occupied by indication information sent by the base station to the terminal device.

In a possible implementation, the types of the plurality of first regions in the target space are determined based on a data feature of the first data in the plurality of first regions.

In a possible implementation, the indication mode is determined based on a data feature of the first data in the target space.

In the solution provided in this application, the types of the plurality of first regions in the target space are determined based on the data feature of the first data in the plurality of first regions, and the terminal device may indicate the terminal device to perform region-based compression, to balance communication resources and performance. However, determining the indication mode based on the data feature of the first data in the target space can reduce a quantity of bits occupied by indication information sent by the terminal device to a base station.

In a possible implementation, the method further includes: receiving environment information sent by the base station, where the environment information represents location information of at least one piece of second data in the target space; and removing first data that is in the first data and that falls within a preset range of the location information, to obtain the target data.

In the solution provided in this application, the second data is data historically obtained by the base station, that is, existing data of the base station. First data near a location of the second data is more likely to be the existing data of the base station, or data that is not needed by the base station under some precision requirements. Therefore, the first data that is in the first data and that falls within the preset range of location information of the second data is removed, effectiveness of compressing transmission data can be further improved, and communication efficiency can be improved.

In a possible implementation, the environment information includes environment compression indication information and location compression information, and the method further includes: decompressing the location compression information based on the environment compression indication information to obtain the location information.

In the solution provided in this application, the environment information received by the terminal device is compressed data, and a data transmission amount can be reduced by transmitting the compressed data.

In a possible implementation, the compression level is determined based on capacity information of a transmission resource.

In the solution provided in this application, the compression level is determined based on the capacity information of the transmission resource, so that the compression level can flexibly adapt to communication resources and performance.

In a possible implementation, the compression mode is determined based on a precision requirement of the base station for the target data and/or based on a data feature of the first data in the target region.

In the solution provided in this application, a compression mode of each target region is flexibly determined based on the data feature of the first data in the target region and/or the precision requirement for the target data, and a unified compression mode is not used for all target regions, so that compression efficiency can be improved. Further, a compression parameter and the compression mode of each target region may also be flexibly determined based on the data feature of the first data in the target region and/or the precision requirement for the target data.

In a possible implementation, the compression mode is determined based on types of the plurality of target regions and a mapping relationship, where the mapping relationship is a mapping relationship between the compression mode and the type.

In the solution provided in this application, the mapping relationship between the compression mode and the type is pre-determined on both a base station side and a terminal device side, so that information about the determined compression mode does not need to be added to transmitted compression information. This reduces a data transmission amount.

According to a second aspect, an embodiment of this application provides a data compression method. The method may be applied to a base station, or may be applied to an apparatus (for example, a chip, a chip system, or a circuit) in the base station, or may be an apparatus that can be used together with the base station. This is not limited herein. The following provides descriptions by using an example in which the method is applied to the base station. The method includes:

receiving compression information, where the compression information is determined based on indication information and first data, the indication information includes types of a plurality of first regions in target space, the target space is determined based on a space boundary, and the first data is data in the target space.

In the solution provided in this application, the compression information received by the base station is determined based on the indication information (for example, the types of the plurality of first regions in the target space) and the first data. In other words, different types of first regions correspond to different compression degrees. The targeted data compression method can improve effectiveness of compressing transmission data and improve communication efficiency.

It should be understood that the second aspect may be performed by the base station, and specific content of the second aspect corresponds to the content of the first aspect. For corresponding characteristics of the second aspect and beneficial effects achieved by the second aspect, refer to the descriptions of the first aspect. To avoid repetition, detailed descriptions are properly omitted herein.

In a possible implementation, the compression information is obtained by compressing target data in a plurality of target regions based on the indication information, the first data, and a compression level, the compression level is one of N compression levels, an $M^{th}$ compression level represents compressing first data in first regions of M types, the $M^{th}$ compression level is one of the N compression levels, N is a positive integer, M is a positive integer not greater than N, and the plurality of target regions are the plurality of first regions in the target space.

In a possible implementation, the compression information is obtained by compressing the target data in the plurality of target regions based on the indication information, the first data, the compression level, and a compression mode. The compression mode includes a subtree mode and a quantization mode.

In a possible implementation, the plurality of target regions are regions that are in the plurality of first regions and that include the first data.

In a possible implementation, the indication information includes an indication mode, the indication mode indicates a manner of the types of the plurality of first regions, and the indication mode includes a grid mode and a space tree mode.

In a possible implementation, the indication mode is determined based on a data feature of second data in the target space.

In a possible implementation, the indication mode is determined based on a data feature of the first data in the target space.

In a possible implementation, the types of the plurality of first regions in the target space are determined based on a data feature of the second data in the plurality of first regions.

In a possible implementation, the types of the plurality of first regions in the target space are determined based on a data feature of the first data in the plurality of first regions.

In a possible implementation, the method further includes: sending environment information, where the environment information represents location information of at least one piece of second data in the target space.

In a possible implementation, the environment information includes environment compression indication information and location compression information, and the location information is obtained by decompressing the location compression information based on the environment compression indication information.

In a possible implementation, the compression level is determined based on capacity information of a transmission resource.

In a possible implementation, the compression mode is determined based on a precision requirement of the base station for the target data and/or based on a data feature of the first data in the target region.

In a possible implementation, the compression mode is determined based on types of the plurality of target regions and a mapping relationship, where the mapping relationship is a mapping relationship between the compression mode and the type.

According to a third aspect, an embodiment of this application provides a communication apparatus.

For beneficial effects, refer to descriptions of the first aspect. Details are not described herein again. The communication apparatus has a function of implementing the behavior in the method instance in the first aspect. The function may be implemented by hardware, or may be implemented by hardware executing corresponding software. The hardware or the software includes one or more modules corresponding to the foregoing function.

In a possible implementation, the communication apparatus includes:

a processing unit, configured to determine compression information based on indication information and first data, where the indication information includes types of a plurality of first regions in target space, the target space is determined based on a space boundary, and the first data is data in the target space; and

a sending unit, configured to send the compression information.

In a possible implementation, the apparatus further includes:

a determining unit, configured to determine a compression level, where the compression level is one of N compression levels, an $M^{th}$ compression level represents compressing first data in first regions of M types, the $M^{th}$ compression level is one of the N compression levels, N is a positive integer, and M is a positive integer not greater than N; and the processing unit is further configured to compress target data in a plurality of target regions based on the compression level to obtain the compression information, where the plurality of target regions are the plurality of first regions in the target space.

In a possible implementation,
the determining unit is further configured to determine a compression mode, where the compression mode includes a subtree mode and a quantization mode.

The processing unit is further configured to compress the target data in the plurality of target regions based on the compression level and the compression mode to obtain the compression information, where the plurality of target regions are the plurality of first regions in the target space.

In a possible implementation, the plurality of target regions are regions that are in the plurality of first regions and that include the first data.

In a possible implementation, the indication information includes an indication mode, the indication mode indicates a manner of the types of the plurality of first regions, and the indication mode includes a grid mode and a space tree mode.

In a possible implementation, the indication mode is determined based on a data feature of second data in the target space.

In a possible implementation, the indication mode is determined based on a data feature of the first data in the target space.

In a possible implementation, the types of the plurality of first regions in the target space are determined based on a data feature of the second data in the plurality of first regions.

In a possible implementation, the types of the plurality of first regions in the target space are determined based on a data feature of the first data in the plurality of first regions.

In a possible implementation, the apparatus further includes:

a receiving unit, configured to receive environment information sent by a base station, where the environment information represents location information of at least one piece of second data in the target space; and the processing unit is further configured to remove first data that is in the first data and that falls within a preset range of the location information, to obtain the target data.

In a possible implementation, the environment information includes environment compression indication information and location compression information.

The processing unit is further configured to decompress the location compression information based on the environment compression indication information to obtain the location information.

In a possible implementation, the compression level is determined based on capacity information of a transmission resource.

In a possible implementation, the compression mode is determined based on a precision requirement of the base station for the target data and/or based on a data feature of the first data in the target region.

In a possible implementation, the compression mode is determined based on types of the plurality of target regions and a mapping relationship, where the mapping relationship is a mapping relationship between the compression mode and the type.

According to a fourth aspect, an embodiment of this application provides a communication apparatus.

For beneficial effects, refer to descriptions of the second aspect. Details are not described herein again. The communication apparatus has a function of implementing the behavior in the method instance in the second aspect. The function may be implemented by hardware, or may be implemented by hardware executing corresponding software. The hardware or the software includes one or more modules corresponding to the foregoing function.

In a possible implementation, the communication apparatus includes:
a receiving unit, configured to receive compression information, where the compression information is determined based on indication information and first data, the indication information includes types of a plurality of first regions in target space, the target space is determined based on a space boundary, and the first data is data in the target space.

In a possible implementation, the compression information is obtained by compressing target data in a plurality of target regions based on the indication information, the first data, and a compression level, the compression level is one of N compression levels, an $M^{th}$ compression level represents compressing first data in first regions of M types, the $M^{th}$ compression level is one of the N compression levels, N is a positive integer, M is a positive integer not greater than N, and the plurality of target regions are the plurality of first regions in the target space.

In a possible implementation, the compression information is obtained by compressing the target data in the plurality of target regions based on the indication information, the first data, the compression level, and a compression mode. The compression mode includes a subtree mode and a quantization mode.

In a possible implementation, the plurality of target regions are regions that are in the plurality of first regions and that include the first data.

In a possible implementation, the indication information includes an indication mode, the indication mode indicates a manner of the types of the plurality of first regions, and the indication mode includes a grid mode and a space tree mode.

In a possible implementation, the indication mode is determined based on a data feature of second data in the target space.

In a possible implementation, the indication mode is determined based on a data feature of the first data in the target space.

In a possible implementation, the types of the plurality of first regions in the target space are determined based on a data feature of the second data in the plurality of first regions.

In a possible implementation, the types of the plurality of first regions in the target space are determined based on a data feature of the first data in the plurality of first regions.

In a possible implementation, the apparatus further includes:

a sending unit, configured to send environment information, where the environment information represents location information of at least one piece of second data in the target space.

In a possible implementation, the environment information includes environment compression indication information and location compression information, and the location information is obtained by decompressing the location compression information based on the environment compression indication information.

In a possible implementation, the compression level is determined based on capacity information of a transmission resource.

In a possible implementation, the compression mode is determined based on a precision requirement of a base station for the target data and/or based on a data feature of the first data in the target region.

In a possible implementation, the compression mode is determined based on types of the plurality of target regions and a mapping relationship, where the mapping relationship is a mapping relationship between the compression mode and the type.

According to a fifth aspect, a communication apparatus is provided. The communication apparatus may be a terminal device, or may be an apparatus (for example, a chip, a chip system, or a circuit) in the terminal device. The apparatus may include a processor, a memory, an input interface, and an output interface. The input interface is configured to receive information from a communication apparatus other than the communication apparatus. The output interface is configured to output information to a communication apparatus other than the communication apparatus. The processor invokes a computer program stored in the memory to perform the data compression method provided in any one of the first aspect or the implementations of the first aspect.

According to a sixth aspect, a communication apparatus is provided. The communication apparatus may be a base station, or may be an apparatus (for example, a chip, a chip system, or a circuit) in the base station. The apparatus may include a processor, a memory, an input interface, and an output interface. The input interface is configured to receive information from a communication apparatus other than the communication apparatus. The output interface is configured to output information to a communication apparatus other than the communication apparatus. The processor invokes a computer program stored in the memory to perform the data compression method provided in any one of the second aspect or the implementations of the second aspect.

According to a seventh aspect, this application provides a computer-readable storage medium. The computer-readable storage medium stores computer instructions, and when a computer program or the computer instructions are run, the method according to any one of the first aspect and the possible implementations of the first aspect, and according to any one of the second aspect and the possible implementations of the second aspect is performed.

According to an eighth aspect, this application provides a chip system. The chip system includes a processor, and may further include a memory, configured to implement the method in any one of the first aspect and the possible implementations of the first aspect, and in any one of the second aspect and the possible implementations of the second aspect. The chip system may include a chip, or may include a chip and another discrete component.

According to a ninth aspect, this application provides a communication system. The communication system includes at least one terminal device and at least one base station. When the at least one terminal device and the at least one base station run in the communication system, the at least one terminal device and the at least one base station are configured to perform any transmission mode determining method according to the first aspect and the second aspect.

According to a tenth aspect, this application provides a computer program product including executable instructions. When the computer program product runs on user equipment, the method according to any one of the first aspect and the possible implementations of the first aspect and the second aspect and the possible implementations of the second aspect is performed.

## BRIEF DESCRIPTION OF DRAWINGS

To describe the technical solutions in embodiments of this application more clearly, the following briefly describes the accompanying drawings for describing embodiments.

FIG. 1 is a diagram of a network architecture according to an embodiment of this application;
FIG. 2 is a schematic flowchart of a data compression method according to an embodiment of this application;
FIG. 3 is a diagram of target space according to an embodiment of this application;
FIG. 4 is a diagram of a plurality of first regions according to an embodiment of this application;
FIG. 5 is a diagram of indicating a type in a grid mode according to an embodiment of this application;
FIG. 6 is a diagram of indicating a type in a space tree mode according to an embodiment of this application;
FIG. 7 is a schematic flowchart of another data compression method according to an embodiment of this application;
FIG. 8 is a diagram of a structure of a communication apparatus according to an embodiment of this application;
FIG. 9 is a diagram of a structure of another communication apparatus according to an embodiment of this application;
FIG. 10 is a diagram of a structure of still another communication apparatus according to an embodiment of this application; and
FIG. 11 is a diagram of a structure of a terminal device according to an embodiment of this application.

## DESCRIPTION OF EMBODIMENTS

In the specification, the claims, and the accompanying drawings of this application, the terms "first", "second", and the like are merely intended to distinguish between different objects, but do not limit a sequence, a time sequence, a priority, or an importance degree of a plurality of objects. In embodiments of this application, "a plurality of" refers to two or more. In addition, the terms such as "include" and "have" and any other variants thereof are intended to cover a non-exclusive inclusion. For example, processes, methods, systems, products, or devices that include a series of steps or units are not limited to listed steps or units, but instead, optionally further include steps or units that are not listed, or optionally further include other steps or units inherent to these processes, methods, products, devices, or the like. In addition, unless otherwise stated, the character "/" usually indicates an "or" relationship between associated objects.

An "embodiment" mentioned in this specification means that a particular characteristic, structure, or feature described with reference to this embodiment may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that the embodiments described in this specification may be combined with another embodiment.

A terminal device in embodiments of this application may be user equipment (user equipment, UE), an access terminal, a subscriber unit, a subscriber station, a mobile station, a remote station, a remote terminal, a mobile device, a user terminal, a terminal, a wireless communication device, a user agent, a user apparatus, or the like. The terminal device may further refer to a terminal apparatus that implements a communication function in this application, for example, a communication module or a communication chip in the terminal apparatus. The terminal device may be a device that provides voice and/or data connectivity for a user, and may alternatively include a device that can perform sidelink (sidelink) communication, for example, a vehicle-mounted terminal, or a handheld terminal that can perform vehicle-to-everything (vehicle-to-everything, V2X) communication. For example, the terminal device may alternatively be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device, another processing device connected to a wireless modem, a vehicle-mounted device, a wearable device, a terminal device in a future 5G network, a terminal device in a future evolved public land mobile network (public land mobile network, PLMN), or the like. This is not limited in embodiments of this application.

A base station in embodiments of this application may include various forms of base stations, for example, a macro base station, a micro base station (also referred to as a small cell), a relay station, an access point, or a relay station or an access point, or a vehicle-mounted device, a wearable device, a next generation NodeB (the next generation NodeB, gNB) in a 5G system, or a base station in a future evolved PLMN network. In a possible manner, the base station may be a base station (for example, the gNB) in an architecture in which a central unit (central unit, CU) and a distributed unit (distributed unit, DU) are separated.

The technical solutions provided in embodiments of this application may be applied to various communication systems, for example, a 5th generation (5th generation, 5G) mobile communication system, a narrowband internet of things (narrowband internet of things, NB-IoT) system, a wireless local area network (wireless local area network, WLAN), wireless fidelity (wireless fidelity, Wi-Fi), a device-to-device (device- to-device, D2D) communication system, a machine to machine (machine to machine, M2M) communication system, a machine type communication (machine type communication, MTC) system, a vehicle to vehicle (vehicle to vehicle, V2V) communication system, another future evolved communication system, and a next generation communication system. Details are not listed one by one herein. Embodiments of this application may also be applied to a non-terrestrial network (non-terrestrial network, NTN), for example, a satellite communication system. Satellite communication has advantages of a wide coverage area, a long communication distance, high reliability, high flexibility, and high throughput.

Environment reconstruction is to establish a mathematical model suitable for computer representation and processing of an objective world environment, which is used to establish a virtual reality for representing the objective world in a computer. The environment reconstruction is applicable in various fields. For example, in the field of autonomous driving, an obstacle avoidance problem of an autonomous driving vehicle in a driving process can be effectively resolved through the environment reconstruction.

In an environment reconstruction process, after obtaining data through scanning, the terminal device uploads the data to the base station to restore an environment. However, because there may be data of regions that cover each other in data obtained by sensors of a plurality of terminal devices through scanning, if all the data obtained through scanning is uploaded, duplicate data may be transmitted. Consequently, communication efficiency is reduced. Therefore, how to improve communication efficiency of a device and a base station is an urgent problem to be resolved.

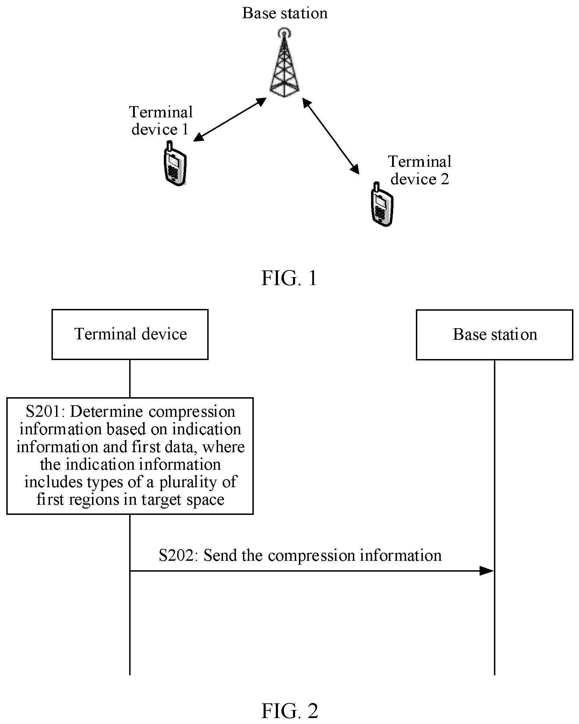

FIG. 1 is a diagram of a network architecture according to an embodiment of this application. As shown in FIG. 1, the communication system may include at least one base station and at least one terminal device. FIG. 1 shows one base station and two terminal devices. The base station provides a communication service for the terminal device. The base station may include a baseband unit (baseband unit, BBU) and a remote radio unit (remote radio unit, RRU). The BBU and the RRU may be deployed in different places. For example, the RRU is remotely deployed in a heavy-traffic region, and the BBU is deployed in a central equipment room. Alternatively, the BBU and the RRU may be deployed in a same equipment room. Alternatively, the BBU and the RRU may be different components at a same rack.

For example, in the communication system, a terminal device 1 uses different compression manners (for example, different compression modes and different compression parameters in the different compression modes) in a plurality of first regions in target space based on indication information (for example, types of the plurality of first regions in the target space), compresses first data in the plurality of first regions to obtain compression information, and sends the compression information to a base station. The compression information includes a compressed data stream and a compression manner. The compression manner is a manner of compressing the first data in the plurality of first regions to obtain the compressed data stream. After receiving the compression information, the base station decompresses the compressed data stream in the compression information based on the compression manner in the compression information, to obtain original data (that is, the first data). In this way, the terminal device 1 and the base station complete a compression information transmission process of data compression, data transmission, and data decompression. When a terminal device (which may be the terminal device 1, or may be another terminal device such as a terminal device 2) performs data transmission with the base station next time, the original data (the first data) obtained by the base station this time becomes data historically received by the base station, that is, historical data (second data).

The target space is determined based on a space boundary, and the space boundary is determined based on a range of the first data obtained by the terminal device. Therefore, when a same terminal device, for example, the terminal device 1 transmits data to the base station for a plurality of times, target space formed by the first data each time obtained by the terminal device 1 may completely overlap (for example, when the terminal device 1 is located at a fixed location, and an operation that causes a range change of the first data obtained by the terminal device 1 is not performed on the terminal device 1); or may not overlap at all (for example, when a location of the terminal device 1 changes and/or an operation that causes a range change of the first data obtained by the terminal device 1 is performed on the terminal device 1); or may be partially spatially overlapped (for example, when a location of the terminal device 1 changes and/or an operation that causes a range change of the first data obtained by the terminal device 1 is performed, but the change is not large, there are partially overlapping ranges in ranges of the first data obtained by the terminal device 1 for a plurality of times). For different terminal devices, for example, the terminal device 1 and the terminal device 2, target space formed by first data obtained by the terminal device 1 and target space formed by first data obtained by the terminal device 2 may completely overlap, or may not overlap at all, or may be partially overlapped. This is not limited in this application. The base station receives and decompresses, for a plurality of times, compression information sent by a plurality of terminal devices, to increase an amount of data obtained by the base station, so that the base station can perform another operation based on the obtained large amount of data. For example, when the data is perception data, imaging data, or point cloud data, the base station reconstructs an environment based on data (data obtained by decompressing a compressed data stream in compression information) obtained from the plurality of terminal devices, so that a reconstructed environment is more comprehensive and refined.

With reference to the foregoing diagram of the network architecture, the following describes a data compression method provided in an embodiment of this application. FIG. 2 is a schematic flowchart of a data compression method according to an embodiment of this application. As shown in FIG. 2, the method may include the following step S201 and step S202.

Step S201: A terminal device determines compression information based on indication information and first data, where the indication information includes types of a plurality of first regions in target space, the target space is determined based on a space boundary, and the first data is data in the target space.

The target space may be a cube that includes spatial locations of all first data obtained this time. The cube in this application includes a cuboid and a regular cube. In other words, the target space may be determined based on a range of the first data obtained by the terminal device. The first data may be obtained by the terminal device by using a sensor. A field of the first data may include location information (for example, values of an X axis, a Y axis, and a Z axis) representing the first data. The location information of the first data is a location of the first data when the terminal device obtains the first data. The field of the first data may further include a field such as a characteristic (for example, a color) of a location represented by the first data. This is not limited in this embodiment of this application.

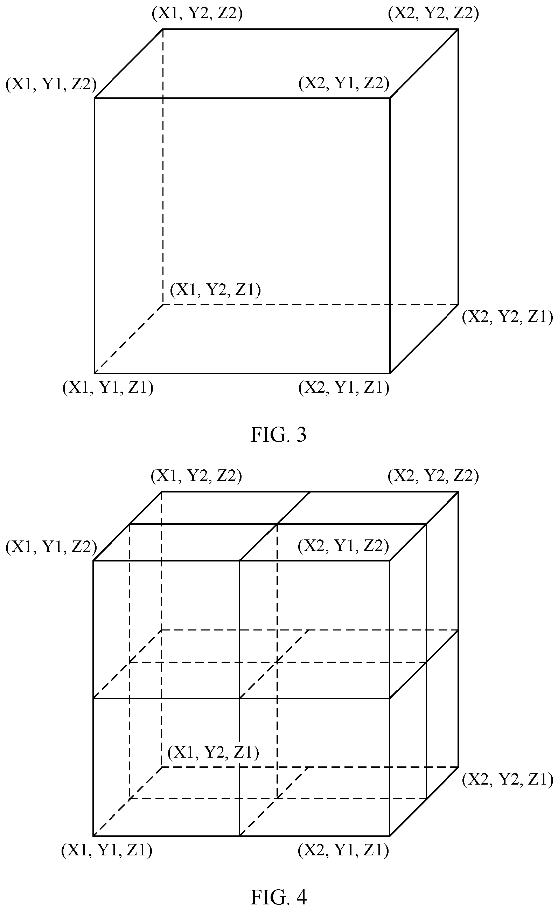

FIG. 3 is a diagram of target space according to an embodiment of this application. Eight vertices of the target space shown in FIG. 3 are (X1, Y1, Z1), (X1, Y1, Z2), (X1, Y2, Z1), (X1, Y2, Z2), (X2, Y1, Z1), (X2, Y1, Z2), (X2, Y2, Z1), and (X2, Y2, Z2).

In a possible implementation, a world coordinate system may be used to represent a location in space. The world coordinate system is an absolute coordinate system of a system. Coordinates of all points are determined based on an origin of the coordinate system. In other words, based on the world coordinate system, a coordinate of any location is fixed, and does not vary with different locations of a terminal device and/or a base station.

In a possible implementation, a space boundary of the target space shown in FIG. 3 may be represented by six pieces of data: X1 and X2 (a maximum value and a minimum value on an X axis), Y1 and Y2 (a maximum value and a minimum value on a Y axis), and Z1 and Z2 (a maximum value and a minimum value on a Z axis). In other words, after receiving the space boundary including the six pieces of data, the base station may determine, based on the six pieces of data, the target space shown in FIG. 3.

In a possible implementation, a space boundary for determining the target space shown in FIG. 3 may be represented by data of the eight vertices (X1, Y1, Z1), (X1, Y1, Z2), (X1, Y2, Z1), (X1, Y2, Z2), (X2, Y1, Z1), (X2, Y1, Z2), (X2, Y2, Z1) and (X2, Y2, Z2) of the target space. In other words, after receiving the space boundary including the eight vertices, the base station may determine, based on the eight vertices, the target space shown in FIG. 3.

It should be noted that the target space shown above is three-dimensional space. In addition, the target space may alternatively be two-dimensional space or the like. Similar to the foregoing two manners of representing the space boundary, four pieces of data: X1 and X2 (a maximum value and a minimum value on an X axis), and Y1 and Y2 (a maximum value and a minimum value on a Y axis) may be used to represent the space boundary. Alternatively, data of four vertices (X1, Y1), (X1, Y2), (X2, Y1) and (X2, Y2) may be used to represent the space boundary.

In a possible implementation, if target space formed by first data obtained by the terminal device is always the same, the terminal device may send a space boundary to the base station in a process of transmitting compression information to the base station for a first time, so that the base station may determine the target space based on the space boundary, and the terminal device no longer send the space boundary to the base station in a subsequent process of transmitting the compression information to the base station. Instead, the target space used when the compression information is transmitted to the base station for the first time is used as the target space used when the compression information is transmitted to the base station subsequently.

In a possible implementation, for a same terminal device, if target space formed by first data obtained by the terminal device for a plurality of times is the same in a period of time, the terminal device may send a space boundary to the base station when transmitting compression information to the base station for a first time in the period of time, and no longer send the space boundary to the base station when transmitting the compression information to the base station subsequently in the period of time. If the target space formed by the first data obtained by the terminal device for the plurality of times changes, when the target space changes, the terminal device sends a space boundary corresponding to a current target space to the base station, so that the base station re-determines the target space based on the new space boundary. In other words, if receiving the space boundary, the base station may determine the target space based on the received space boundary. If receiving no space boundary, the base station may use the previous target space as the current target space, or use a space boundary that is sent by the terminal device and that is received by the base station last time as the current space boundary to determine the target space. To determine whether the space boundary needs to be sent to the base station, the terminal device may first determine whether target space formed by currently obtained first data completely overlaps target space formed by using last obtained first data. If the target space formed by the currently obtained first data completely overlaps the target space formed by the last obtained first data, the space boundary is not sent. If the target space formed by the currently obtained first data and the target space formed by the last obtained first data do not completely overlap or do not overlap at all, the space boundary is first sent to the base station, so that the base station can determine new target space. In a possible implementation, if the current target space is included in the previous target space, it may be equivalent to that the current target space completely overlaps the previous target space, or a space boundary may not be sent.

It can be learned that when the target space formed by the first data obtained for the plurality of times does not change, a same space boundary does not need to be sent to the base station each time, so that an amount of unnecessary data transmission can be reduced.

The base station or the terminal device may obtain a plurality of first regions by dividing the target space. A quantity of first regions obtained by dividing the target space may be determined based on a division granularity d. d is a positive integer. The quantity of first regions = $2^{d*3}$. For example, when d=1, the target space may be divided into eight first regions. When d=2, the target space may be divided into 64 first regions. It should be noted that sizes of the $2^{d*3}$ first regions may be the same or may be different. For example, when d=1, division with a granularity of 1 is separately performed based on a midpoint in a length, a width, and a height of the target space, and eight first regions of a same size may be obtained. If at least one point in the length, the width, and the height of the target space is not a midpoint for division (for example, division is performed based on a data feature of the first data/second data in the target space), eight first regions whose sizes are not completely the same may be obtained.

FIG. 4 is a diagram of a plurality of first regions according to an embodiment of this application. In FIG. 4, the target space shown in FIG. 3 is divided into a plurality of first regions. A division granularity d for dividing the target space to obtain the plurality of first regions is 1. Therefore, eight first regions are obtained in FIG. 4. Coordinates of eight vertices of one first region are respectively $(X1, Y1, Z1)$, $(X1, Y1, \frac{(Z1+Z2)}{2})$, $(X1, \frac{(Y1+Y2)}{2}, Z1)$, $(X1, \frac{(Y1+Y2)}{2}, \frac{(Z1+Z2)}{2})$, $(\frac{(X1+X2)}{2}, Y1, Z1)$, $(\frac{(X1+X2)}{2}, Y1, \frac{(Z1+Z2)}{2})$, $(\frac{(X1+X2)}{2}, \frac{(Y1+Y2)}{2}, Z1)$, and $(\frac{(X1+X2)}{2}, \frac{(Y1+Y2)}{2}, \frac{(Z1+Z2)}{2})$.

In a possible implementation, types of the plurality of first regions in the target space may be determined by the base station based on a data feature of second data in the plurality of first regions.

The second data may be data represented by compression information that is sent by another terminal device and/or a current terminal device and that is received by the base station before the base station receives compression information this time. The data feature of the second data in the plurality of first regions includes but is not limited to an amount of second data in the plurality of first regions, a range of the second data, distribution of the second data, and the like. This is not limited in this embodiment of this application.

For example, the types of the plurality of first regions in the target space are determined based on an amount of second data in the plurality of first regions. It is assumed that the amount of second data in one first region is N. If N=0, it is determined that the type of the first region is a type a. If $0<N\leq T$, it is determined that the type of the first region is a type b. If N>T, it is determined that the type of the first region is a type c. When the types are represented by data, 0 may represent the type a, 10 may represent the type b, and 11 may represent the type c. Alternatively, 0 may represent the type a, 1 may represent the type b, and 2 may represent the type c. Alternatively, another representation manner may be used. This is not limited in this embodiment of this application.

For example, the types of the plurality of first regions in the target space are determined based on a range of the second data in the plurality of first regions. It is assumed that a range of second data in one first region is M. If M<M1, it is determined that the type of the first region is a type a. If $M1\leq M<M2$, it is determined that the type of the first region is a type b. If $M2\leq M<M3$, it is determined that the type of the first region is a type c. If $M\geq M3$, it is determined that the type of the first region is a type d. The range of the second data in the first region may be an absolute value of a difference between minimum second data and maximum second data in the first region, or may be a distance between two pieces of second data that are farthest apart in the first region. This is not limited in this embodiment of this application.

For example, the types of the plurality of first regions in the target space are determined based on a density of second data in the plurality of first regions. It is assumed that a density of second data in one first region is P. If P=0, it is determined that the type of the first region is a type a. If P<P1, it is determined that the type of the first region is a type b. If $P\geq P1$, it is determined that the type of the first region is a type c. The density of the second data in the plurality of first regions may be a percentage of an amount of second data in the first region to a region size (for example, an area or a volume) of the first region, or may be a percentage of an amount of second data in the first region to a range of the second data in the first region. This is not limited in this embodiment of this application.

In a possible implementation, the types of the plurality of first regions in the target space may be determined by the terminal device based on a data feature of first data in the plurality of first regions. The data feature of the first data in the plurality of first regions includes but is not limited to an amount of first data in the plurality of first regions, a range of the first data, a density of the first data, and the like. For calculation manners of the data feature of the first data, refer to the foregoing calculation manners of the amount of second data, the range of the second data, and the density of the second data in the plurality of first regions. Details are not described herein again. For example, the types of the plurality of first regions in the target space are determined based on the amount of first data in the plurality of first regions. It is assumed that an amount of first data in one first region is n. If n=0, it is determined that the type of the first region is a type a. If $0<n\leq t$, it is determined that the type of the first region is a type b. If n>t, it is determined that the type of the first region is a type c. For example, the types of the plurality of first regions in the target space are determined based on the range of the first data in the plurality of first regions. It is assumed that a range of first data in one first region is m. If m<m1, it is determined that the type of the first region is a type a. If $m1\leq m<m2$, it is determined that the type of the first region is a type b. If $m2\leq m<m3$, it is determined that the type of the first region is a type c. If $m\geq m3$, it is determined that the type of the first region is a type d. For example, the types of the plurality of first regions in the target space are determined based on the density of the first data in the plurality of first regions. It is assumed that a density of first data in one first region is p. If $p\geq p1$, it is determined that the type of the first region is a type a. If $0<p<p1$, it is determined that the type of the first region is a type b. If p=0, it is determined that the type of the first region is a type c.

The second data is data that is sent by the terminal device and that is historically received by the base station. A field of the second data may include a field representing location information (for example, values of an X axis, a Y axis, and a Z axis) of the second data. The location information of the second data is a location of the second data when the terminal device obtains the second data. The field of the second data may further include a field of a characteristic (for example, a color) of the location represented by the second data, and the like. It may be understood that the second data in the first region is second data whose location is in space represented by the first region. Similarly, it may be learned that the first data in the first region is first data whose location is in space represented by the first region. The second data in the target space is second data whose location is in space represented by the target space. The first data in the target space is first data whose location is in space represented by the target space.

It should be noted that classifying the first region into the type a to the type c is an example of this embodiment of this application, and should not constitute any limitation on this embodiment of this application. For example, when the types of the plurality of first regions in the target space are determined based on the amount of second data in the plurality of first regions, the first region may alternatively be classified into four types of regions: a type a to a type d. It is assumed that the amount of the second data in the first region is N. If N=0, it is determined that the type of the first region is a type a. If $0<N\leq T$, it is determined that the type of the first region is a type b. If $T<N\leq Q$, it is determined that the type of the first region is a type c. If N>Q, it is determined that the type of the first region is a type d.

In a possible implementation, indication information includes an indication mode. The indication mode indicates a manner of the types of the plurality of first regions, and the indication mode includes a grid mode and a space tree mode.

The indication mode indicates a manner in which the base station/the terminal device organizes data that represents the types of the plurality of first regions and that is sent to the terminal device/the base station.

In the grid mode, one piece of data represents a type of a first region. Therefore, when the grid mode indicates the types of the plurality of first regions, a needed data amount is fixed at $2^{d*3}$.

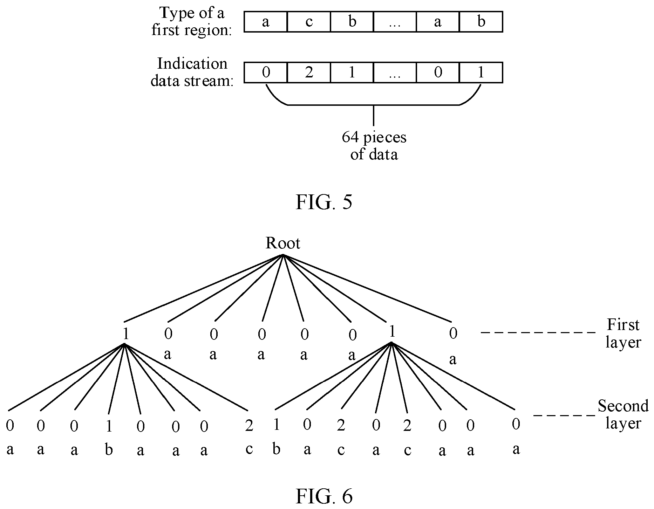

For example, a value of d is 2, the types include three types: a type a to a type c, and 0, 1, and 2 respectively represent the type a to the type c. When the value of d is 2, the target space is divided into $2^{2*3}$, that is, 64, first regions. A type of each region is represented by one piece of data. Therefore, a total of 64 pieces of data are needed. FIG. 5 is a diagram of indicating a type in a grid mode according to an embodiment of this application. Types of the 64 first regions included in the target space shown in FIG. 5 are respectively a type a, a type c, a type b, ..., a type a, and a type b. Indication data streams indicating the types of the 64 first regions in the grid mode are 021...01.

In the space tree mode, a leaf node of an octree represents the type of the first region.

For example, a value of d is 2, the types include three types: a type a to a type c, and 0, 1, and 2 respectively represent the type a to the type c. FIG. 6 is a diagram of indicating a type in a space tree mode according to an embodiment of this application. root represents the target space, and a, b, and c represent the type a, the type b, and the type c. A node at a first layer corresponds to a block obtained by performing region division on the target space at a granularity of 1. A node at a second layer corresponds to a first region obtained by performing region division on the block at a granularity of 1, in other words, corresponds to the first region obtained by performing region division on the target space at a granularity of 2. It may be understood that the block includes a plurality of first regions. It may be understood that each time a quantity of layers of the space tree is increased by one, it indicates that one more region division at a granularity of 1 is performed on the target space. In the space tree mode shown in FIG. 6, the leaf node represents the type of the first region, and a value of the leaf node may be 0, 1, or 2, which respectively correspond to the type a, the type b, and the type c. A value of a non-leaf node is 1, which indicates that the block includes second data. For example, data 1 in the first layer indicates that the block includes the second data, and may be divided again. Data 0 in the first layer indicates that the block does not include the second data, in other words, the plurality of first regions obtained by performing region division on the block do not include the second data. Therefore, when data of the first layer is 0, the block corresponding to the data does not need to be further divided. Indication data streams indicating, in the space tree mode, the types of the 64 first regions corresponding to FIG. 5 are 24 pieces of data in total: 10000010, 00010002, and 10202000. Therefore, a proper selection of the indication mode can reduce a data transmission amount.

In a possible implementation, if the types of the plurality of first regions are determined based on a data feature of the second data in the plurality of first regions, the indication mode is correspondingly determined based on the data feature of the second data in the target space. The data feature of the second data in the target space includes but is not limited to an amount of second data in the target space, a range of the second data, distribution of the second data, and the like. This is not limited in this embodiment of this application.

In a possible implementation, if the types of the plurality of first regions are determined based on a data feature of the first data in the plurality of first regions, the indication mode is correspondingly determined based on the data feature of the first data in the target space. The data feature of the first data in the target space includes but is not limited to an amount of first data in the target space, a range of the first data, distribution of the first data, and the like. This is not limited in this embodiment of this application.

For the data feature of the first data in the target space and the data feature of the second data in the target space, refer to the foregoing descriptions of the data feature of the first data in the plurality of first regions and the data feature of the second data in the plurality of first regions. Details are not described herein again.

It can be learned from the grid mode shown in FIG. 5, the space tree mode shown in FIG. 6, and the foregoing examples that when the amount of second data/first data in the target space is small or the density is low, a data amount needed for indicating a type in the space tree mode is less than a data amount needed for indicating a type in the grid mode. Therefore, when the amount of second data/first data in the target space is not greater than a preset threshold Q, the space tree mode may be used to indicate the type; or when the amount of second data in the target space is greater than a preset threshold Q, the grid mode may be used to indicate the type. Alternatively, the indication mode may be determined depending on whether a percentage of a quantity of regions including the second data/the first data to a total quantity of first regions in the target space is greater than a preset percentage Q1%. For example, when the percentage of the quantity of regions including the second data/the first data to the total quantity of first regions in the target space is not greater than the preset percentage Q1%, the space tree mode is used to indicate the type; or when the percentage of the quantity of regions including the second data/the first data to the total quantity of first regions in the target space is greater than the preset percentage Q1%, the grid mode is used to indicate the type. This is not limited in this embodiment of this application.

In a possible implementation, for the target space, both the space tree mode and the grid mode may be used to indicate the types of the plurality of first regions. For example, the target space is divided into a sub-target space 1 and a sub-target space 2. An amount of second data in the sub-target space 1 is larger or denser, and an amount of second data in the sub-target space 2 is smaller or sparser. Therefore, for the sub-target space 1, the grid mode may be used for indication, and for the sub-target space 2, the space tree mode may be used for indication. It should be noted that dividing the target space into two sub-target spaces is an example, and should not constitute any limitation on this embodiment of this application. In addition, space sizes of a plurality of sub-target spaces are not limited in this embodiment of this application.

It should be noted that, if the types of the plurality of first regions and the indication mode are determined by the base station, after determining the types of the plurality of first regions and the indication mode, the base station needs to deliver the determined types of the plurality of first regions and the indication mode determined by the base station to the terminal device, so that the terminal device obtains a type of each first region. If the types of the plurality of first regions and the indication mode are determined by the terminal device, after determining the types of the plurality of first regions and the indication mode, the terminal device needs to upload the determined types of the plurality of first regions and the indication mode determined by the terminal device to the base station, so that the base station obtains a type of each first region.

The target space may be a cube that includes spatial locations of all first data obtained this time. Therefore, the first data is data in the target space.

A terminal may learn the types of the plurality of first regions in the target space based on indication information. Therefore, the terminal may compress the first data in the first regions of different types to different degrees based on the known types of the plurality of first regions. For example, as described above, the first region corresponding to the type a does not include the second data, in other words, there is no historical data in the first region corresponding to the type a. Therefore, for the first region corresponding to the type a, all first data in the first region may be sent to the base station, and a case in which communication efficiency is reduced because transmitted data and the second data are repeated does not occur. For the type c, an amount of second data in the first region corresponding to the type c is greater than a preset value T. In other words, a large amount of historical data already exists in the first region corresponding to the type c. If a compression manner of the type c is the same as the compression manner of the first region corresponding to the type a, in other words, all first data in the first region whose type is the type c is compressed and transmitted to the base station, it is more likely that the second data in the first region corresponding to the type c and the first data are repeated. Therefore, not all the first data in the first region corresponding to the type c may be sent to the base station. It may be understood that, because a purpose of sending the compression information is to enable the base station to decompress a compressed data stream based on the received compression manner to obtain the original first data, sending the first data in the first region to the base station in this embodiment of this application refers to: compressing the first data in a compression manner to obtain a compressed data stream, and sending compression information including the compression manner and the compressed data stream to the base station.

In a possible implementation, determining the compression information based on the indication information and the first data may include: determining a compression level, where the compression level is one of N compression levels, an $M^{th}$ compression level represents compressing first data in first regions of M types, the $M^{th}$ compression level is one of the N compression levels, N is a positive integer, and M is a positive integer not greater than N; and compressing target data in a plurality of target regions based on the compression level to obtain the compression information, where the plurality of target regions are the plurality of first regions in the target space.

The compression level may be determined based on capacity information of a transmission resource and/or an acceptable distortion degree. Distortion is also referred to as distorted. It refers to a difference between a signal and an original signal or a standard during transmission. In an ideal amplifier, an output waveform needs to be the same as an input waveform except for amplification. However, actually, the output waveform cannot be the same as the input waveform. This phenomenon is referred to as distortion.

In a possible implementation, a manner of determining the compression level may be as follows: The base station determines the capacity information of the transmission resource that can be allocated to the terminal device and/or the acceptable distortion degree, and sends the capacity information of the transmission resource and/or the acceptable distortion degree to the terminal device, and the terminal device determines the compression level based on the capacity information of the transmission resource.

In a possible implementation, a method for determining the compression level may be: The base station sends the compression level to the terminal device after determining the compression level based on the capacity information of the transmission resource that can be allocated to the terminal device and/or the acceptable compression distortion degree.

In a possible implementation, the terminal device may determine the compression level and/or a size of a requested resource based on performance of the terminal device and/or a compression distortion degree that can satisfy a data requirement, and then send the compression level and/or the size of the requested resource to the base station. The base station determines whether to accept the compression level by determining whether the compression level satisfies the capacity information of the transmission resource that can be allocated to the terminal device and/or the acceptable distortion degree, or the base station accepts, by default, the compression level determined by the terminal device.

The N compression levels may be respectively represented as a first compression level, a second compression level, a third compression level, ..., and an $N^{th}$ compression level. For example, when N=3, the three compression levels may be respectively the first compression level, the second compression level, and the third compression level. The first compression level may represent compressing first data in a first region of a type (for example, the type a) in the plurality of first regions. The second compression level may represent compressing first data in first regions of two types (the type a and the type b) in the plurality of first regions. The third compression level may represent compressing first data in first regions of three types (for example, the type a, the type b, and the type c) in the plurality of first regions. When N=4, it indicates that there are four compression levels: the first compression level to the fourth compression level. If the determined compression level is the first compression level, the plurality of compressed first regions may be first data in the plurality of first regions whose types are the type a. Alternatively, the data feature of the first data in the plurality of first regions are comprehensively considered (for example, an amount, a range, and a density of the first data in the plurality of first regions are separately weighted), and it is determined that the plurality of compressed first regions are first data in the plurality of first regions whose types are the type b or the type c. This is not limited in this embodiment of this application.

In a possible implementation, the plurality of target regions may be regions that are in the plurality of first regions and that include the first data. If a first region does not include the first data, the first region may not be used as the target region. Similarly, the space tree mode or the grid mode may be used to indicate whether each first region includes the first data. It may be understood that, that the first region includes the first data means that the first data is obtained from the first region. For example, the grid mode is used for indication. 0 may indicate that the first region does not include the first data, and 1 may indicate that the first region includes the first data. When the space tree mode is used for indication, 0 may also indicate that the first region does not include the first data, and 1 may indicate that the first region includes the first data. However, different from using the space tree mode to indicate the type, when the space tree mode indicates whether the first region includes the first data, data 2 does not appear, and a meaning represented by data of a non-root node (a leaf node and a non-leaf node) is whether the first region includes the first data.

The target data is a part of first data or all first data in the target region.

After the compression level is determined, which region is the target region is further clarified. For example, a region type includes the type a to the type c, and the compression level is determined as the first compression level. In other words, only the first data in the first region corresponding to the type a is compressed and transmitted. In this case, the target region is the first region that includes the first data and whose type is the type a. Neither the first region that does not include the first data and whose type is the type a nor the first region that includes/does not include the first data and whose type is the type b or the type c is the target region.

In a possible implementation, determining the compression information based on the indication information and the first data may include: determining a compression mode, where the compression mode includes a subtree mode and a quantization mode; and compressing the target data in the plurality of target regions based on the compression mode to obtain the compression information, where the plurality of target regions are the plurality of first regions in the target space.

In the subtree mode, a space subtree is established for each target region, and a leaf node in the space subtree represents a group. Leaf nodes at a same layer (a same depth) represent a same size of a group, and leaf nodes at different layers (different depths) represent different sizes of groups. Because a group represented by a leaf node at a non-last layer does not include the first data, data corresponding to a leaf node at a last layer may represent all target data in the group.

That data corresponding to the leaf node represents all the target data in the group means that an error between the target data in the group and the data corresponding to the leaf node (for example, data at a central location of the group) is within an acceptable range. If an error between the target data in the group and the data of the leaf node is not within the acceptable range, the leaf node needs to be re-divided to obtain a leaf node representing a smaller group. The division may be stopped until data corresponding to a leaf node can represent all target data in a group corresponding to the leaf node. It should be noted that the data corresponding to the leaf node is not data on the leaf node (for example, 1 in the space subtree), but data in space of a group represented by the leaf node, for example, data at a central location of the group, or data that is selected from the group based on a preset manner and that can represent all target data in the group.

In the field of data signal processing, quantization refers to approximation of consecutive values (or a large quantity of possible discrete values) of a signal into a limited quantity of (or few) discrete values. In this embodiment of this application, the quantization mode is reducing bit overheads needed for data, for example, a data compression manner in which a 32-bit or 16-bit floating point number is approximately represented by using 8 bits.

In a possible implementation, when the target data is compressed in the quantization manner, for a part of the target region, only a part of the target data may be quantized. For example, when the target data is compressed in the quantization manner, if the target data in the target region whose type is the type c needs to be compressed, only 50% of the target data in the target region whose type is the type c may be quantized. When the target data is compressed in the quantization manner, a quantization boundary of compressed target data may be a boundary of the target region to which the target data belongs.

In a possible implementation, the target data in one target region may be compressed with reference to the subtree mode and the quantization mode. For example, there is a target region A, the target region A may be divided into a sub-target region A1 to a sub-target region A64, and target data in the target region A is centralized in the sub-target region A1 and the sub-target region A9. The sub-target region A1 may be divided into a sub-target region A11 to a sub-target region A18, and the sub-target region A9 may be divided into a sub-target region A91 to a sub-target region 98. Target data in the sub-target region A1 is centralized in the sub-target region A12, and target data in the sub-target region A9 is centralized in the sub-target region A98. The target data is dispersedly distributed in the sub-target region A12 and the sub-target region A98. Therefore, for the target region A, two layers may be compressed in the subtree manner first, and then the target data in the sub-target region A12 and the sub-target region A98 is compressed in the quantization mode.

In a possible implementation, determining the compression information based on the indication information and the first data may include: determining a compression level, where the compression level is one of N compression levels, an $M^{th}$ compression level represents compressing first data in first regions of M types, the $M^{th}$ compression level is one of the N compression levels, N is a positive integer, and M is a positive integer not greater than N; compressing the target data in the plurality of target regions based on the compression mode to obtain the compression information, where the plurality of target regions are the plurality of first regions in the target space; and compressing the target data in the plurality of target regions based on the compression level and the compression mode to obtain the compression information, where the plurality of target regions are the plurality of first regions in the target space.

In this embodiment of this application, a sequence of determining the compression level and determining the compression mode by the terminal device is not limited.

Fields in the compression information include a compression mode, a compression parameter, and a compressed data stream. The compression mode includes the foregoing subtree mode and quantization mode. When the compression mode is the subtree mode, the compression parameter may be a subtree depth of a space subtree of each target region, and the compressed data stream may be a bit stream formed by data represented by a node of the space subtree of each target region. The compressed data stream may alternatively be a bit stream obtained by using an entropy coding technology for data represented by a node of the space subtree of each target region. When the compression mode is the quantization mode, the compression parameter may be an amount of target data in each target region and a quantization granularity of a coordinate axis, and the compressed data stream may be a bit stream obtained by quantizing the target data in each target region and using an entropy coding technology for the target data. The quantization granularity indicates a bit overhead for representing one piece of data. For example, if the quantization granularity is 8, it indicates that one piece of data is represented by using 8 bits. The entropy coding technology is a lossless data compression technology. It may be understood that the base station may decompress the compressed data stream by using two fields, namely, the compression mode and the compression parameter, in the compression information, to obtain the target data.

The compression information may be organized in a plurality of forms. A default form of the compression information may be set, or an organization form used for the compression information may be additionally indicated.

Table 1 shows an organization form of compression information according to an embodiment of this application.

| Common compression mode | Compression parameter of each target region | Compressed data stream in the target region |
|---|---|---|

It can be learned that, in Table 1, only the compression mode of each target region is the same.

Table 2 shows another organization form of compression information according to an embodiment of this application.

| Common compression mode | Common compression parameter | Compressed data stream in a target region |
|---|---|---|

It can be learned that, in Table 2, the compression mode and the compression parameter of each target region are the same.

Table 3 shows still another organization form of compression information according to an embodiment of this application.

| Compression mode of each target region | Compression parameter of each target region | Compressed data stream in the target region |
|---|---|---|

It can be learned that, in Table 3, the compression mode and the compression parameter of each target region are different.

It should be noted that, if the quantization manner is selected for each target region and the compression parameter is the same, an amount of target data in each target region (or block) needs to be recorded, so that the base station may perform decompression based on a corresponding decompression boundary.

In a possible implementation, when the target region does not include the entire first region, the compression information may further include the compression level and/or target region indication information, to obtain the target region in the first region, so that the base station may determine, based on the compression level and/or the target region indication information, a target region to which a decompressed compressed data stream of the target region belongs. Therefore, when decompressing the compressed data stream of the target region, the base station may determine, based on a boundary of the target region, a decompression boundary (for example, a quantization boundary) for decompressing the compressed data stream of the corresponding target region.

In a possible implementation, an implementation of the target region indication information may be sending the target region indication information to the base station in the space tree mode or the grid mode. For example, 0 indicates that a first region is not a target region, and 1 indicates that a first region is a target region. Alternatively, when the first region without the target data is one or more first regions of a same type, and all other first regions except the one or more first regions of the same type are target regions with the target data, the target region indication information may not be sent. Alternatively, which regions are target regions is indicated. For example, 3, 5, and 7 are sent to the base station, indicating that a $3^{rd}$ first region, a $5^{th}$ first region, and a $7^{th}$ first region are target regions, and other first regions are not target regions. Alternatively, which regions are non-target regions is indicated. For example, 2, 4, and 8 are sent to the base station, indicating that a $2^{nd}$ first region, a $4^{th}$ first region, and an $8^{th}$ first region are not target regions, and other first regions are all target regions. Alternatively, the compression parameter of the target region may indicate whether a region is a target region. For example, in the quantization mode, one piece of data represents an amount of target data in the target region, and another piece of data represents a quantization granularity in the target region. For example, if the amount of target data in the compression parameter of the target region is 0 and/or the quantization granularity is 0, it indicates that there is no target data in the first region, in other words, the first region is actually not the target region. For example, in the subtree mode, if a depth of the subtree is 0, it may indicate that there is no target data in a first region (or group) corresponding to the subtree, and the first region (or group) is not the target region.

In a possible implementation, the compression level and/or the target region indication information may not be included in the compression information, but is separately sent to the base station from the compression information.

In a possible implementation, the compression mode may be determined based on a precision requirement of the base station for the target data and/or based on the amount of first data in the target region.

For example, when the base station has a high precision requirement for the target data and/or there is a small amount of second data in the target space, the target data may be compressed in the quantization mode. When the base station has a low precision requirement for the target data and/or there is a large amount of second data in the target space, the target data may be compressed in the subtree mode.

In a possible implementation, the compression mode may be determined based on types of a plurality of target regions and a mapping relationship.

The mapping relationship is a mapping relationship between the compression mode and the type. The terminal device or the base station may establish the mapping relationship between the type and the compression mode in advance (for example, when the terminal device transmits the compression information to the base station for the first time) based on an average amount of first data in each type of target region and/or a precision requirement for data (which may be determined based on a ratio of a quantity of target regions including the second data to a total quantity of target regions), and then send the mapping relationship to the base station or the terminal device. In this way, the compression mode may be determined based on the mapping relationship during subsequent transmission of the compression information. Further, in the subsequent transmission of the compression information, the mapping relationship may also be dynamically adjusted.

Table 4 shows a mapping table between a type and a compression mode according to an embodiment of this application.

| Type | Type a | Type b | Type c |
|---|---|---|---|
| Compression mode | 0 or 1 | 0 | 1 |

In the compression mode, 0 represents the quantization mode, and 1 represents the subtree mode. It can be learned from the mapping table between the type and the compression mode shown in Table 4 that, for a target region of the type a, target data may be compressed in the subtree mode or the quantization mode, for a target region of the type b, target data may be compressed in the quantization mode, and for a target region of the type c, target data may be compressed in the subtree mode.

In a possible implementation, the terminal device or the base station may establish a mapping table between the type, the compression mode, and the compression parameter in advance based on an average amount of first data in each type of target region and/or a precision requirement for data (which may be determined based on a ratio of a quantity of target regions including second data to a total quantity of target regions), and the like.

Table 5 shows a mapping table between a type, a compression mode, and a compression parameter according to an embodiment of this application.

| Type | Type a | Type b | Type c |
|---|---|---|---|
| Compression mode | 0 or 1 | 0 | 1 |
| Compression parameter | 8 or 3 | 5 | 2 |

In the compression mode, 0 represents the quantization mode, and 1 represents the subtree mode. In the compression parameter, 8 and 5 indicate the quantization granularity, and 3 and 2 indicate a depth of the subtree. It can be learned from the mapping table between the type and the compression mode shown in Table 4 that, for the target region of the type a, the target data may be compressed in the subtree mode (the depth of the subtree is 3) or the quantization mode (the quantization granularity is 8), for the target region of the type b, the target data may be compressed in the quantization mode (the quantization granularity is 5), and for the target region of the type c, the target data may be compressed in the subtree mode (the depth of the subtree is 2). It may be understood that compression modes and/or compression parameters of first regions of different types may be the same or may be different.

For a case in which there are more types, a mapping relationship may also be correspondingly set, and details are not described herein.

Step S202: The terminal device sends the compression information. Correspondingly, the base station receives the compression information.

After receiving the compression information, the base station sequentially decompresses compressed data streams based on the compression manner that is included in the compression information and that is for the compressed data streams to obtain the first data, and adds the first data to the second data, so that the second data becomes second data of the base station.

In a possible implementation, the boundary of the target region and the amount of compressed target data in the target region may be obtained based on the determined target region, and the compressed data streams in the target region are sequentially decompressed to obtain the first data. For example, the target region includes a target region 1 and a target region 2. There is one piece of target data in the target region 1. There are three pieces of target data in the target region 2. The target region 2 is located behind the target region 1, and there is no other target region in the target region 1 and the target region 2. In this case, after the base station decompresses a compressed data stream in the target region corresponding to one piece of target data, a compressed data stream to be next decompressed in the target region is a compressed data stream in the target region corresponding to the three pieces of target data in the target region 2.

In a possible implementation, after determining the type of each first region, the terminal device/base station may further cluster target regions of a same type based on a data feature of the target data, to obtain different categories of target regions in a same type of target region. The target regions of the same type are sorted based on categories, in other words, compressed data streams corresponding to target data in target regions of a same category are placed together to form a segment of consecutive compressed data streams in the target region. For example, a target region 1 to a target region 4 are four consecutive target regions. Types of the target region 1, the target region 2, and the target region 4 is a type a, and a type of the target region 3 is a type b. In this case, the target region 1, the target region 2, and the target region 4 may be clustered based on data features of first data in the target region 1, the target region 2, and the target region 4. For example, the target region 1 and the target region 4 are clustered into a category 0, and the target region 2 is clustered into a category 1 based on densities of the target data in the target region 1, the target region 2, and the target region 4. If a sequential decompression manner is used, a decompression sequence of the base station is the target region 1 to the target region 4. After the clustering, because the compressed data streams in the target region corresponding to the target data in the target region 1 and the target region 4 are consecutive, a decompression sequence of the base station is also correspondingly changed. For example, the sequence is changed to a sequence of the target region 1, the target region 4, the target region 2, and the target region 3. To enable the base station to obtain locations of target regions of a same type and different categories, a bitmap may indicate the target regions of the same type and the different categories. For example, 0 indicates that a target region whose category is the category 0 in the type, and 1 indicates that a target region whose category is the category 1 in the type. In this case, 010 indicates categories of the target region 1, the target region 2, and the target region 4. Therefore, after decompressing a compressed data stream in target data corresponding to target data in the target region 1 (the category 0) based on 010, the base station searches for, in the target region of the same type, whether there is a target region of the same category as the target region 1. In this example, it may be learned that the category of the target region 4 is also the category 0, which is the same as the category of the target region 1. Therefore, after the compressed data stream in the target region corresponding to the target data in the target region 1 is decompressed, a compressed data stream in a target region corresponding to target data in the target region 4 is decompressed immediately. Compression and decompression gains can be improved by clustering the target regions of the same category. It may be understood that different compression manners may be used for target regions of a same type but different categories.

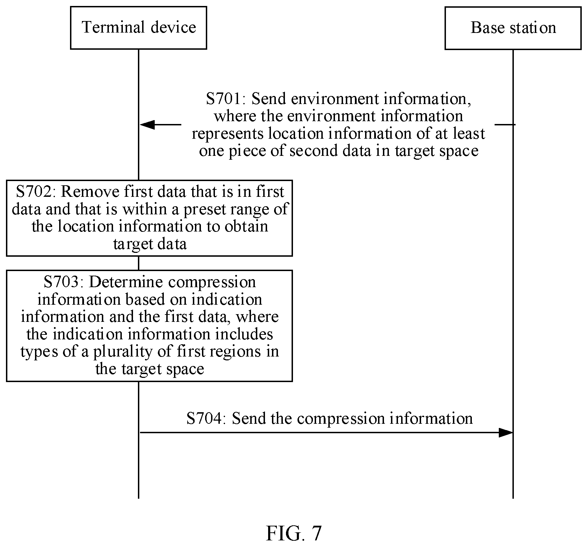

FIG. 7 is a schematic flowchart of another data compression method according to an embodiment of this application. As shown in FIG. 7, the method may include the following step S701 to step S704.

Step S701: A base station sends environment information, where the environment information represents location information of at least one piece of second data in target space. Correspondingly, a terminal device receives the environment information.

In a possible implementation, the at least one piece of second data corresponding to the environment information is randomly selected by the base station from second data included in the target space.

In a possible implementation, the at least one piece of second data corresponding to the environment information is selected by the base station according to a preset rule from second data included in the target space. For example, the preset rule may be: presetting a space size of subspace, and if an amount of second data in the subspace is greater than G, or the amount of the second data in the subspace is greater than K% of a total amount of the second data in the target space, selecting specific second data in the subspace as the second data related to the environment information. For example, the selected second data may be second data at a central location of the subspace, or the central location of the subspace may be used as the second data, or the second data may be selected in some other manners (for example, randomly selected). This is not limited in this embodiment of this application. G is a positive integer, and K is a positive number. The space size of the subspace is less than a space size of the target space. The subspace may be located in the target space, or may be space that has an overlapping part with the target space. If the subspace partially overlaps the target space, the selected second data is second data in overlapping space. It may be understood that the subspace is not space having a fixed location, but space having a fixed space size. For example, the second data in the target space may be used as the central location of the subspace to establish the subspace. Further, if locations of two or more pieces of second data in the second data selected by the base station are less than a preset distance, one piece of second data in the second data may be reserved.

In a possible implementation, the environment information includes environment compression indication information and location compression information. A terminal decompresses the location compression information based on the environment compression indication information to obtain the location information.

In a possible implementation, the location information may be fine-grained location information. For example, a plurality of pieces of location compression information may include one or more pieces of location compression information that uses location compression information of one piece of second data to indicate location information of one piece of second data. After receiving and decompressing the location compression information indicating location information of one piece of second data, the terminal device may correspondingly obtain the location information of the one piece of second data. Location information indicated by the fine-grained location information is more accurate.

In a possible implementation, the location information may be coarse-grained location information. For example, a plurality of pieces of location compression information may include one or more pieces of location compression information that uses location compression information of one piece of second data to indicate location information of a plurality of pieces of second data within a preset range of the second data. After receiving and decompressing the location compression information indicating the location information of the plurality of pieces of second data, the terminal device may obtain the location information of the plurality of pieces of second data. The coarse-grained location information occupies fewer bits in a transmission process.

In other words, in a possible implementation, the environment information sent by the base station to the terminal device does not include original data of the location information of the second data, but includes compressed data (that is, the location compression information) obtained by compressing the location information of the second data.

The environment compression indication information includes an indication mode and an indication parameter. In other words, the environment information includes the indication mode, the indication parameter, and the location compression information. For the indication mode, refer to the foregoing compression mode. In other words, the indication mode includes the foregoing subtree mode and the foregoing quantization mode. Correspondingly, for the indication parameter, refer to the compression parameters in the foregoing different compression modes.

Therefore, it may be understood that the environment information may also be organized in a plurality of forms. A default form of the environment information may be set, or an organization form used for the environment information may be additionally indicated.

Table 6 shows an organization form of environment information according to an embodiment of this application.

| Common indication mode | Indication parameter of each second region | Compressed data stream in the second region |
|---|---|---|

It can be learned that, in Table 6, only the indication mode of each second region is the same. It may be understood that the second region is one or more first regions of a plurality of first regions. The compressed data stream in the second region represents the location compression information.

Table 7 shows another organization form of environment information according to an embodiment of this application.

| Common indication mode | Common indication parameter | Compressed data stream in a second region |
|---|---|---|

It can be learned that, in Table 7, the indication mode and the indication parameter of each second region are the same.

Table 8 shows still another organization form of environment information according to an embodiment of this application.

| Indication mode of each second region | Indication parameter of each second region | Compressed data stream in the second region |
|---|---|---|

It can be learned that, in Table 8, the indication mode and the indication parameter of each second region are different. The second region is a first region in which the location information of the second data delivered by the base station to the terminal device is located.

In a possible implementation, the base station determines, based on whether the environment information needs to be delivered to various types of regions, a type of a region to which the environment information needs to be delivered. 1-bit may sequentially indicate whether the environment information in each type of region needs to be delivered. For example, if only environment information of a type c needs to be delivered in a type a to the type c, 001 may indicate that only environment information of the first region of the type c needs to be delivered. Then, the terminal obtains, based on a received indication indicating the type of the region in which the delivered second data is located, a region boundary that is in the target space and that corresponds to the type of the region in which the second data is located, and uses the region boundary as a decompression boundary (for example, a quantization boundary) for decompressing a compressed data stream in the target region.

In a possible implementation, the type of the region to which the environment information needs to be delivered may not be determined depending on whether the environment information needs to be delivered to each type of region. Refer to the foregoing implementation in which the target region indication information indicates the target region, to indicate which region is the second region. Details are not described herein again.

In a possible implementation, the base station delivers a decompression boundary, which is used as a decompression boundary when the terminal device decompresses a compressed data stream in the target region.

The decompression boundary is used to determine a range of the target data. In other words, a value of the target data is within a range of a value formed by the decompression boundary.

After receiving the environment information, the terminal device may decompress the location compression information (the compressed data stream) based on the environment compression indication information (the indication mode and the indication parameter), to obtain the location information of the second data.

Step S702: The terminal device removes first data that is in the first data and that falls within a preset range of the location information, to obtain the target data.

The location information is the location information of the second data delivered by the base station. If the base station already has second data at the location, it indicates that the base station has a small requirement for first data at the location. Therefore, the terminal device may remove, based on the location information, a part of the first data that is within the preset range of the location information to obtain the target data.

In a possible implementation, the preset range may be a sub-region of the location of the second data. For example, after receiving the location information of the second data, the terminal device may determine the first region of the second data. It is assumed that the first region is a region 1. The region 1 is divided into a sub-region 11 to a sub-region 18, and the received second data is located in the sub-region 11. Therefore, the first data in the sub-region 11 is removed.

In a possible implementation, the preset range may be a range formed when the location of the second data is less than a preset distance value.

Step S703: The terminal device determines compression information based on indication information and the first data, where the indication information includes types of a plurality of first regions in the target space, the target space is determined based on a space boundary, and the first data is data in the target space.

It may be understood that step S701 corresponds to step S201. For related descriptions in step S701, refer to the foregoing descriptions in step S201. To avoid repetition, details are not described herein again.

Step S704: The terminal device sends the compression information. Correspondingly, the base station receives the compression information.

It may be understood that the compression information is actually determined based on the indication information and some first data (that is, the target data).

It may be understood that step S703 and step S704 correspond to step S201 and step S202. For related descriptions in step S703 and step S704, refer to the descriptions in step S201 and step S202. To avoid repetition, details are not described herein again.

The foregoing describes the method embodiments provided in embodiments of this application. The following describes virtual apparatus embodiments in embodiments of this application.

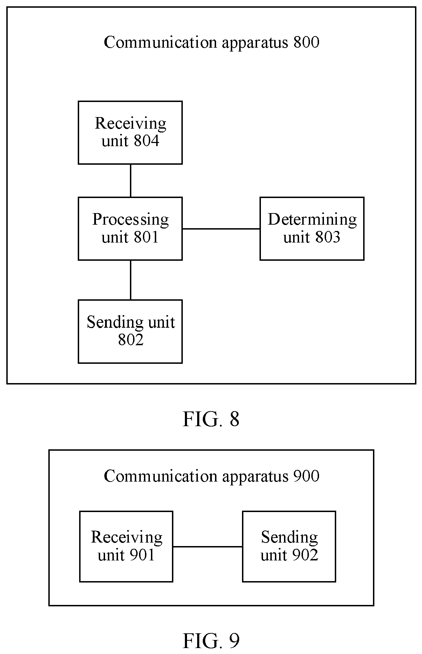

FIG. 8 is a diagram of a structure of a communication apparatus according to an embodiment of this application. The communication apparatus may be a terminal device, or may be a module (for example, a chip) in the terminal device. As shown in FIG. 8, the communication apparatus 800 may include a processing unit 801, a sending unit 802, a determining unit 803, and a receiving unit 804.

The processing unit 801 is configured to determine compression information based on indication information and first data, where the indication information includes types of a plurality of first regions in target space, the target space is determined based on a space boundary, and the first data is data in the target space.

The sending unit 802 is configured to send the compression information.

Optionally, the determining unit 803 is configured to determine a compression level, where the compression level is one of N compression levels, an $M^{th}$ compression level represents compressing first data in first regions of M types, the $M^{th}$ compression level is one of the N compression levels, N is a positive integer, and M is a positive integer not greater than N.

The processing unit 801 is further configured to compress target data in a plurality of target regions based on the compression level to obtain the compression information, where the plurality of target regions are the plurality of first regions in the target space.

Optionally, the determining unit 803 is further configured to determine a compression mode, where the compression mode includes a subtree mode and a quantization mode.

The processing unit 801 is further configured to compress the target data in the plurality of target regions based on the compression level and the compression mode to obtain the compression information, where the plurality of target regions are the plurality of first regions in the target space.

Optionally, the plurality of target regions are regions that are in the plurality of first regions and that include the first data.

Optionally, the indication information includes an indication mode, the indication mode indicates a manner of the types of the plurality of first regions, and the indication mode includes a grid mode and a space tree mode.

Optionally, the indication mode is determined based on a data feature of second data in the target space.

Optionally, the indication mode is determined based on a data feature of the first data in the target space.

Optionally, the types of the plurality of first regions in the target space are determined based on a data feature of the second data in the plurality of first regions.

Optionally, the types of the plurality of first regions in the target space are determined based on a data feature of the first data in the plurality of first regions.

Optionally, the receiving unit 804 is configured to receive environment information sent by a base station, where the environment information represents location information of at least one piece of second data in the target space.

The processing unit 801 is further configured to remove first data that is in the first data and that falls within a preset range of the location information, to obtain the target data.

Optionally, the environment information includes environment compression indication information and location compression information.

The processing unit 801 is further configured to decompress the location compression information based on the environment compression indication information to obtain the location information.

Optionally, the compression level is determined based on capacity information of a transmission resource.

Optionally, the compression mode is determined based on a precision requirement of the base station for the target data and/or based on a data feature of the first data in the target region.

Optionally, the compression mode is determined based on types of the plurality of target regions and a mapping relationship, where the mapping relationship is a mapping relationship between the compression mode and the type.

For more detailed descriptions of the processing unit 801, the sending unit 802, the determining unit 803, and the receiving unit 804, refer to related descriptions of the terminal device in the method embodiments shown in FIG. 2 and FIG. 7. Details are not described herein again.

FIG. 9 is a diagram of a structure of another communication apparatus according to an embodiment of this application. The apparatus may be a base station, or may be a module (for example, a chip) in the base station. As shown in FIG. 9, the communication apparatus 900 includes a receiving unit 901 and a sending unit 902.

The receiving unit is configured to receive compression information, where the compression information is determined based on indication information and first data, the indication information includes types of a plurality of first regions in target space, the target space is determined based on a space boundary, and the first data is data in the target space.

Optionally, the compression information is obtained by compressing target data in a plurality of target regions based on the indication information, the first data, and a compression level, the compression level is one of N compression levels, an $M^{th}$ compression level represents compressing first data in first regions of M types, the $M^{th}$ compression level is one of the N compression levels, N is a positive integer, M is a positive integer not greater than N, and the plurality of target regions are the plurality of first regions in the target space.

Optionally, the compression information is obtained by compressing the target data in the plurality of target regions based on the indication information, the first data, the compression level, and a compression mode. The compression mode includes a subtree mode and a quantization mode.

Optionally, the plurality of target regions are regions that are in the plurality of first regions and that include the first data.

Optionally, the indication information includes an indication mode, the indication mode indicates a manner of the types of the plurality of first regions, and the indication mode includes a grid mode and a space tree mode.

Optionally, the indication mode is determined based on a data feature of second data in the target space.

Optionally, the indication mode is determined based on a data feature of the first data in the target space.

Optionally, the types of the plurality of first regions in the target space are determined based on a data feature of the second data in the plurality of first regions.

Optionally, the types of the plurality of first regions in the target space are determined based on a data feature of the first data in the plurality of first regions.

Optionally, the sending unit 902 is configured to send environment information, where the environment information represents location information of at least one piece of second data in the target space.

Optionally, the environment information includes environment compression indication information and location compression information, and the location information is obtained by decompressing the location compression information based on the environment compression indication information.

Optionally, the compression level is determined based on capacity information of a transmission resource.

Optionally, the compression mode is determined based on a precision requirement of the base station for the target data and/or based on a data feature of the first data in the target region.

Optionally, the compression mode is determined based on types of the plurality of target regions and a mapping relationship, where the mapping relationship is a mapping relationship between the compression mode and the type.

For more detailed descriptions of the receiving unit 901 and the sending unit 902, refer to related descriptions of the base station in the method embodiments shown in FIG. 2 and FIG. 7. Details are not described herein again.

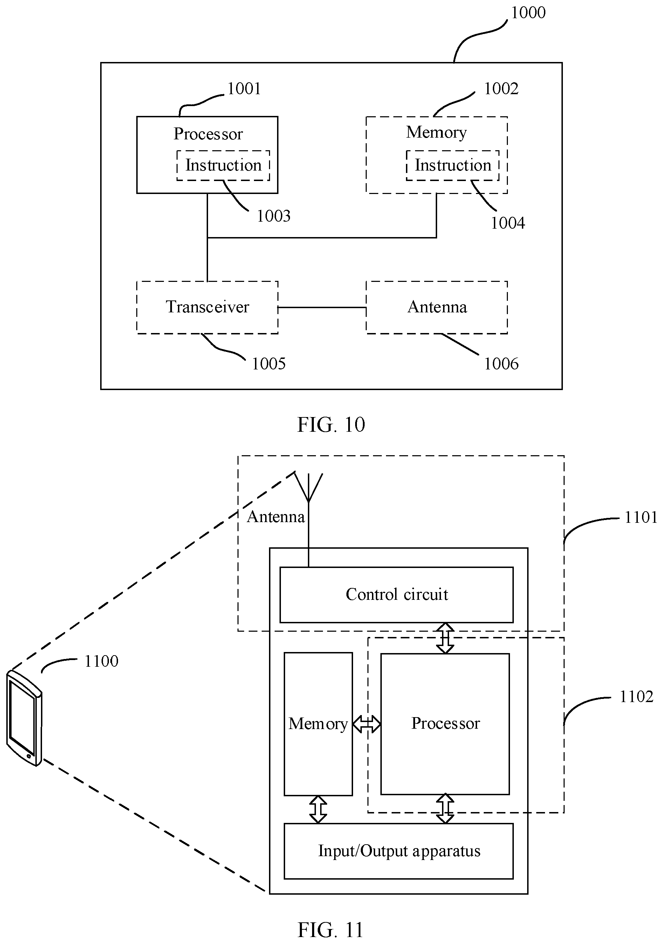

Based on the foregoing network architecture, FIG. 10 is a diagram of a structure of still another communication apparatus according to an embodiment of this application. As shown in FIG. 10, the communication apparatus 1000 may include one or more processors 1001. The processor 1001 may also be referred to as a processing unit, and may implement a control function. The processor 1001 may be a general-purpose processor, a dedicated processor, or the like. For example, the processor 1001 may be a baseband processor or a central processing unit. The baseband processor may be configured to process a communication protocol and communication data. The central processing unit may be configured to: control a communication apparatus (for example, a base station, a baseband chip, a terminal, a terminal chip, a DU, or a CU), execute a software program, and process data of the software program.

In an optional design, the processor 1001 may alternatively store instructions 1003 and/or data, and the instructions 1003 and/or data may be run by the processor 1001, so that the apparatus 1000 performs the methods described in the foregoing method embodiments.

In another optional design, the processor 1001 may include a transceiver unit configured to implement receiving and sending functions. For example, the transceiver unit may be a transceiver circuit, an interface, an interface circuit, or a communication interface. The transceiver circuit, the interface, or the interface circuit configured to implement the receiving and sending functions may be separated, or may be integrated together. The transceiver circuit, the interface, or the interface circuit may be configured to read and write code/data. Alternatively, the transceiver circuit, the interface, or the interface circuit may be configured to transmit or transfer a signal.

In still another possible design, the apparatus 1000 may include a circuit. The circuit may implement a sending, receiving, or communication function in the foregoing method embodiments.

Optionally, the apparatus 1000 may include one or more memories 1002. The memory 1002 may store instructions 1004 and/or data. The instructions 1004 and/or data may be run on the processor, so that the apparatus 1000 performs the methods described in the foregoing method embodiments. Optionally, the memory may further store data. Optionally, the processor may alternatively store instructions and/or data. The processor and the memory may be separately disposed, or may be integrated together. For example, the correspondence described in the foregoing method embodiments may be stored in the memory or stored in the processor.

Optionally, the apparatus 1000 may further include a transceiver 1005 and/or an antenna 1006. The processor 1001 may be referred to as a processing unit, and controls the apparatus 1000. The transceiver 1005 may be referred to as a transceiver unit, a transceiver machine, a transceiver circuit, a transceiver apparatus, a transceiver module, or the like, and is configured to implement a transceiver function.

Optionally, the apparatus 1000 in this embodiment of this application may be configured to perform the methods described in FIG. 2 and FIG. 7 in embodiments of this application.

In an embodiment, the communication apparatus 1000 may be a terminal device, or may be an apparatus (for example, a chip, a chip system, or a circuit) in the terminal device. When computer program instructions stored in the memory 1002 are executed, the processor 1001 is configured to perform operations performed by the determining unit 803 and the processing unit 801 in the foregoing embodiment, and the transceiver 1005 is configured to perform operations performed by the receiving unit 804 and the sending unit 802 in the foregoing embodiment. The transceiver 1005 is further configured to send information to a communication apparatus other than the communication apparatus. The terminal device or the apparatus in the terminal device may be further configured to perform various methods performed by the terminal device in the method embodiments in FIG. 2 and FIG. 7. Details are not described again.

In an embodiment, the communication apparatus 1000 may be a base station, or may be an apparatus (for example, a chip, a chip system, or a circuit) in the base station. When computer program instructions stored in the memory 1002 are executed, the transceiver 1005 is configured to perform operations performed by the receiving unit 901 and the sending unit 902 in the foregoing embodiment. The transceiver 1005 is further configured to receive information from a communication apparatus other than the communication apparatus. The base station or the apparatus in the base station may be further configured to perform various methods performed by the base station in the method embodiments in FIG. 2 and FIG. 7. Details are not described again.

The processor and the transceiver that are described in this application may be implemented on an integrated circuit (integrated circuit, IC), an analog IC, a radio frequency integrated circuit (radio frequency interface chip, RFIC), a hybrid signal IC, an application-specific integrated circuit (application-specific integrated circuit, ASIC), a printed circuit board (printed circuit board, PCB), an electronic device, or the like. The processor and the transceiver may be manufactured by using various IC technologies, for example, a complementary metal oxide semiconductor (complementary metal oxide semiconductor, CMOS), an N-type metal oxide semiconductor (nMetal-oxide-semiconductor, NMOS), a P-type metal oxide semiconductor (positive channel metal oxide semiconductor, PMOS), a bipolar junction transistor (Bipolar Junction Transistor, BJT), a bipolar CMOS (BiCMOS), silicon germanium (SiGe), and gallium arsenicum (GaAs).

The apparatus described in the foregoing embodiments may be a first communication device or a second communication device. However, a scope of the apparatus described in this application is not limited thereto, and a structure of the apparatus may not be limited by that in FIG. 10. The apparatus may be an independent device, or may be a part of a larger device. For example, the apparatus may be:

(1) an independent integrated circuit IC, a chip, a chip system or subsystem;
(2) a set of one or more ICs, where optionally, the IC set may further include a storage component configured to store data and/or instructions;
(3) an ASIC, for example, a modem (MSM);
(4) a module that can be embedded in another device;
(5) a receiver, a terminal, an intelligent terminal, a cellular phone, a wireless device, a handset, a mobile unit, a vehicle-mounted device, a network device, a cloud device, an artificial intelligence device, a machine device, a home device, a medical device, an industrial device, or the like; or
(6) others.

FIG. 11 is a diagram of a structure of a terminal device according to an embodiment of this application. For ease of description, FIG. 11 shows only main components of the terminal device. As shown in FIG. 11, the terminal device 1100 includes a processor, a memory, a control circuit, an antenna, and an input/output apparatus. The processor is mainly configured to: process a communication protocol and communication data, control an entire terminal, execute a software program, and process data of the software program. The memory is mainly configured to store the software program and the data. The radio frequency circuit is mainly configured to: perform conversion between a baseband signal and a radio frequency signal, and process the radio frequency signal. The antenna is mainly configured to receive and send radio frequency signals in a form of an electromagnetic wave. The input/output apparatus, like a touchscreen, a display, or a keyboard, is mainly configured to: receive data input by a user and output data to the user.

After the terminal is powered on, the processor may read the software program in a storage unit, parse and execute instructions of the software program, and process the data of the software program. When data needs to be sent in a wireless manner, the processor performs baseband processing on the to-be-sent data, and outputs a baseband signal to the radio frequency circuit. The radio frequency circuit processes the baseband signal to obtain a radio frequency signal, and sends, through the antenna, the radio frequency signal to the outside in a form of an electromagnetic wave. When data is sent to the terminal, the radio frequency circuit receives the radio frequency signal through the antenna, further converts the radio frequency signal into a baseband signal, and outputs the baseband signal to the processor. The processor converts the baseband signal into data, and processes the data.

For ease of description, FIG. 11 shows only one memory and one processor. In an actual terminal device, there may be a plurality of processors and memories. The memory may also be referred to as a storage medium, a storage device, or the like. This is not limited in embodiments of this application.

In an optional implementation, the processor may include a baseband processor and a central processing unit. The baseband processor is mainly configured to process a communication protocol and communication data, and the central processing unit is mainly configured to: control the entire terminal, execute a software program, and process data of the software program. The processor in FIG. 11 is integrated with functions of the baseband processor and the central processing unit. A person skilled in the art may understand that the baseband processor and the central processing unit may alternatively be processors independent of each other, and are interconnected by using a technology like a bus. A person skilled in the art may understand that the terminal may include a plurality of baseband processors to adapt to different network standards, and the terminal may include a plurality of central processing units to enhance a processing capability of the terminal. All the components of the terminal may be connected through various buses. The baseband processor may alternatively be expressed as a baseband processing circuit or a baseband processing chip. The central processing unit may alternatively be expressed as a central processing circuit or a central processing chip. A function of processing the communication protocol and the communication data may be built in the processor, or may be stored in the storage unit in a form of a software program, and the processor executes the software program to implement a baseband processing function.

In an example, the antenna and the control circuit that have a transceiver function may be considered as a transceiver unit 1101 of the terminal device 1100, and the processor that has a processing function may be considered as a processing unit 1102 of the terminal device 1100. As shown in FIG. 11, the terminal device 1100 includes the transceiver unit 1101 and the processing unit 1102. The transceiver unit may also be referred to as a transceiver, a transceiver machine, a transceiver apparatus, or the like. Optionally, a component that is in the transceiver unit 1101 and that is configured to implement a receiving function may be considered as a receiving unit, and a component that is in the transceiver unit 1101 and that is configured to implement a sending function may be considered as a sending unit. In other words, the transceiver unit 1101 includes the receiving unit and the sending unit. For example, the receiving unit may also be referred to as a receiver machine, a receiver, a receiving circuit, or the like. The sending unit may be referred to as a transmitter machine, a transmitter, a transmitting circuit, or the like. Optionally, the receiving unit and the sending unit may be an integrated unit, or may be a plurality of independent units. The receiving unit and the sending unit may be in one geographical location, or may be distributed in a plurality of geographical locations.

In an embodiment, the processing unit 1102 is configured to perform the operations performed by the determining unit 803 and the processing unit 801 in the foregoing embodiment, and the transceiver unit 1101 is configured to perform the operations performed by the receiving unit 804 and the sending unit 802 in the foregoing embodiment. The terminal device 1100 may be further configured to perform various methods performed by the terminal device in the method embodiments in FIG. 2 and FIG. 7. Details are not described again.

An embodiment of this application further provides a computer-readable storage medium, and the computer-readable storage medium stores a computer program. When the program is executed by a processor, a procedure related to the terminal device in the transmission mode determining method provided in the foregoing method embodiments may be implemented.

An embodiment of this application further provides a computer-readable storage medium, and the computer-readable storage medium stores a computer program. When the program is executed by a processor, a procedure related to the network device in the transmission mode determining method provided in the foregoing method embodiments may be implemented.

An embodiment of this application further provides a computer program product. When the computer program product runs on a computer or a processor, the computer or the processor is enabled to perform one or more steps in any one of the foregoing transmission mode determining methods. When each of component modules of the foregoing device is implemented in a form of a software functional unit and sold or used as an independent product, the component modules may be stored in a computer-readable storage medium.

An embodiment of this application further provides a chip system, including at least one processor and a communication interface. The communication interface is interconnected to the at least one processor via a line. The at least one processor is configured to run a computer program or instructions to perform some or all steps recorded in any one of the method embodiments corresponding to FIG. 2 and FIG. 7. The chip system may include a chip, or may include a chip and another discrete component.

An embodiment of this application further discloses a communication system. The system includes a terminal device and a network device. For specific descriptions, refer to the data compression methods shown in FIG. 2 and FIG. 7.

It should be understood that the memory mentioned in embodiments of this application may be a volatile memory or a non-volatile memory, or may include both a volatile memory and a non-volatile memory. The non-volatile memory may be a hard disk drive (hard disk drive, HDD), a solid-state drive (solid-state drive, SSD), a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of illustrative rather than limitative descriptions, many forms of RAMs are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). The memory is any other medium that can carry or store expected program code in a form of an instruction or a data structure and that can be accessed by a computer, but is not limited thereto. The memory in embodiments of this application may alternatively be a circuit or any other apparatus that can implement a storage function, and is configured to store program instructions and/or data.

It should be further understood that, the processor mentioned in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, a discrete hardware component, or the like. The general-purpose processor may be a microprocessor, or the processor may be any conventional processor or the like.

It should be noted that when the processor is the general-purpose processor, the DSP, the ASIC, the FPGA or the another programmable logic device, the discrete gate, the transistor logic device, or the discrete hardware component, the memory (a storage module) is integrated into the processor.

It should be noted that the memory described in this specification aims to include but is not limited to these memories and any memory of another proper type.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

A person of ordinary skill in the art may be aware that, in combination with units and algorithm steps in the examples described in embodiments provided in this specification, this application may be implemented by electronic hardware or a combination of computer software and electronic hardware. Whether functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for a purpose of convenient and brief description, for a detailed operating process of the foregoing system, apparatus, and unit, refer to a corresponding process in the foregoing method embodiment. Details are not described herein again.

In the several embodiments provided in this application, it should be understood that the disclosed system, apparatus, and method may be implemented in another manner. For example, the described apparatus embodiments are merely examples. For example, division into the units is merely logical function division. There may be another division manner during actual implementation. For example, a plurality of units or components may be combined or integrated into another system, or some characteristics may be ignored or not performed. In addition, the displayed or discussed mutual couplings or direct couplings or communication connections may be implemented through some interfaces. The indirect couplings or communication connections between the apparatuses or units may be implemented in electronic, mechanical, or another form.

The units described as separate components may or may not be physically separate, and components displayed as units may or may not be physical units, in other words, may be located in one location, or may be distributed on a plurality of network units. Some or all of the units may be selected based on an actual requirement to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to a conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the methods described in embodiments of this application. The storage medium includes any medium like a USB flash drive, a removable hard disk, a ROM, a RAM, a magnetic disk, or an optical disc, that can store program code.

A sequence of the steps of the methods in embodiments of this application may be adjusted, combined, and deleted based on an actual requirement.

The modules/units in the apparatuses in embodiments of this application may be combined, divided, and deleted based on an actual requirement.

In conclusion, the foregoing embodiments are merely intended for describing the technical solutions of this application, but not for limiting this application. Although this application is described in detail with reference to the foregoing embodiments, a person of ordinary skill in the art should understand that modifications may still be made to the technical solutions recorded in the foregoing embodiments or equivalent replacements may be made to some technical characteristics thereof, and such modifications or replacements do not cause the essence of the corresponding technical solutions to depart from the scope of the technical solutions of embodiments of this application.

**Claims**

1. A data compression method, wherein the method comprises:

   determining compression information based on indication information and first data, wherein the indication information comprises types of a plurality of first regions in target space, the target space is determined based on a space boundary, and the first data is data in the target space; and
   sending the compression information.

2. The method according to claim 1, wherein the determining compression information based on indication information and first data comprises:

determining a compression level, wherein the compression level is one of N compression levels, an $M^{th}$ compression level represents compressing first data in first regions of M types, the $M^{th}$ compression level is one of the N compression levels, N is a positive integer, and M is a positive integer not greater than N; and compressing target data in a plurality of target regions based on the compression level to obtain the compression information, wherein the plurality of target regions are the plurality of first regions in the target space.

3. The method according to claim 2, wherein the method further comprises:

determining a compression mode, wherein the compression mode comprises a subtree mode and a quantization mode; and
the compressing target data in a plurality of target regions based on the compression level to obtain the compression information, wherein the plurality of target regions are the plurality of first regions in the target space comprises: compressing the target data in the plurality of target regions based on the compression level and the compression mode to obtain the compression information, wherein the plurality of target regions are the plurality of first regions in the target space.

4. The method according to claim 2 or 3, wherein the plurality of target regions are regions that are in the plurality of first regions and that comprise the first data.

5. The method according to any one of claims 1 to 4, wherein the indication information comprises an indication mode, the indication mode indicates a manner of the types of the plurality of first regions, and the indication mode comprises a grid mode and a space tree mode.

6. The method according to claim 5, wherein the indication mode is determined based on a data feature of second data in the target space.

7. The method according to claim 5, wherein the indication mode is determined based on a data feature of the first data in the target space.

8. The method according to any one of claims 1 to 6, wherein the types of the plurality of first regions in the target space are determined based on a data feature of the second data in the plurality of first regions.

9. The method according to any one of claims 1 to 5 or 7, wherein the types of the plurality of first regions in the target space are determined based on a data feature of the first data in the plurality of first regions.

10. The method according to any one of claims 2 to 9, wherein the method further comprises:

receiving environment information sent by a base station, wherein the environment information represents location information of at least one piece of second data in the target space; and
removing first data that is in the first data and that falls within a preset range of the location information, to obtain the target data.

11. The method according to claim 10, wherein the environment information comprises environment compression indication information and location compression information, and the method further comprises:
decompressing the location compression information based on the environment compression indication information to obtain the location information.

12. The method according to any one of claims 2 to 11, wherein the compression level is determined based on capacity information of a transmission resource.

13. The method according to any one of claims 3 to 12, wherein the compression mode is determined based on a precision requirement of the base station for the target data and/or based on a data feature of the first data in the target region.

14. The method according to any one of claims 3 to 12, wherein the compression mode is determined based on types of the plurality of target regions and a mapping relationship, and the mapping relationship is a mapping relationship between the compression mode and the type.

15. A data compression method, wherein the method comprises:

**EP 4 622 222 A1**

receiving compression information, wherein the compression information is determined based on indication information and first data, the indication information comprises types of a plurality of first regions in target space, the target space is determined based on a space boundary, and the first data is data in the target space.

16. The method according to claim 15, wherein the compression information is obtained by compressing target data in a plurality of target regions based on the indication information, the first data, and a compression level, the compression level is one of N compression levels, an $M^{th}$ compression level represents compressing first data in first regions of M types, the $M^{th}$ compression level is one of the N compression levels, N is a positive integer, M is a positive integer not greater than N, and the plurality of target regions are the plurality of first regions in the target space.

17. The method according to claim 16, wherein the compression information is obtained by compressing the target data in the plurality of target regions based on the indication information, the first data, the compression level, and a compression mode, and the compression mode comprises a subtree mode and a quantization mode.

18. The method according to claim 16 or 17, wherein the plurality of target regions are regions that are in the plurality of first regions and that comprise the first data.

19. The method according to any one of claims 15 to 18, wherein the indication information comprises an indication mode, the indication mode indicates a manner of the types of the plurality of first regions, and the indication mode comprises a grid mode and a space tree mode.

20. The method according to claim 19, wherein the indication mode is determined based on a data feature of second data in the target space.

21. The method according to claim 19, wherein the indication mode is determined based on a data feature of the first data in the target space.

22. The method according to any one of claims 15 to 20, wherein the types of the plurality of first regions in the target space are determined based on a data feature of the second data in the plurality of first regions.

23. The method according to any one of claims 15 to 19 or 21, wherein the types of the plurality of first regions in the target space are determined based on a data feature of the first data in the plurality of first regions.

24. The method according to any one of claims 16 to 23, wherein the method further comprises:
sending environment information, wherein the environment information represents location information of at least one piece of second data in the target space.

25. The method according to claim 24, wherein the environment information comprises environment compression indication information and location compression information, and the location information is obtained by decompressing the location compression information based on the environment compression indication information.

26. The method according to any one of claims 16 to 25, wherein the compression level is determined based on capacity information of a transmission resource.

27. The method according to any one of claims 17 to 26, wherein the compression mode is determined based on a precision requirement of a base station for the target data and/or based on a data feature of the first data in the target region.

28. The method according to any one of claims 17 to 26, wherein the compression mode is determined based on types of the plurality of target regions and a mapping relationship, and the mapping relationship is a mapping relationship between the compression mode and the type.

29. A communication apparatus, wherein the apparatus comprises:

a processing unit, configured to determine compression information based on indication information and first data, wherein the indication information comprises types of a plurality of first regions in target space, the target space is determined based on a space boundary, and the first data is data in the target space; and
a sending unit, configured to send the compression information.

30. The apparatus according to claim 29, wherein the apparatus further comprises:

a determining unit, configured to determine a compression level, wherein the compression level is one of N compression levels, an $M^{th}$ compression level represents compressing first data in first regions of M types, the $M^{th}$ compression level is one of the N compression levels, N is a positive integer, and M is a positive integer not greater than N; and
the processing unit is further configured to compress target data in a plurality of target regions based on the compression level to obtain the compression information, wherein the plurality of target regions are the plurality of first regions in the target space.

31. The apparatus according to claim 30, wherein

the determining unit is further configured to determine a compression mode, wherein the compression mode comprises a subtree mode and a quantization mode; and
the processing unit is further configured to compress the target data in the plurality of target regions based on the compression level and the compression mode to obtain the compression information, wherein the plurality of target regions are the plurality of first regions in the target space.

32. The apparatus according to claim 30 or 31, wherein the plurality of target regions are regions that are in the plurality of first regions and that comprise the first data.

33. The apparatus according to any one of claims 29 to 32, wherein the indication information comprises an indication mode, the indication mode indicates a manner of the types of the plurality of first regions, and the indication mode comprises a grid mode and a space tree mode.

34. The apparatus according to claim 33, wherein the indication mode is determined based on a data feature of second data in the target space.

35. The apparatus according to claim 33, wherein the indication mode is determined based on a data feature of the first data in the target space.

36. The apparatus according to any one of claims 29 to 34, wherein the types of the plurality of first regions in the target space are determined based on a data feature of the second data in the plurality of first regions.

37. The apparatus according to any one of claims 29 to 33 or 35, wherein the types of the plurality of first regions in the target space are determined based on a data feature of the first data in the plurality of first regions.

38. The apparatus according to any one of claims 30 to 37, wherein the apparatus further comprises:

a receiving unit, configured to receive environment information sent by a base station, wherein the environment information represents location information of at least one piece of second data in the target space; and
the processing unit is further configured to remove first data that is in the first data and that falls within a preset range of the location information, to obtain the target data.

39. The apparatus according to claim 38, wherein the environment information comprises environment compression indication information and location compression information; and
the processing unit is further configured to decompress the location compression information based on the environment compression indication information to obtain the location information.

40. The apparatus according to any one of claims 30 to 39, wherein the compression level is determined based on capacity information of a transmission resource.

41. The apparatus according to any one of claims 31 to 40, wherein the compression mode is determined based on a precision requirement of the base station for the target data and/or based on a data feature of the first data in the target region.

42. The apparatus according to any one of claims 31 to 40, wherein the compression mode is determined based on types of the plurality of target regions and a mapping relationship, and the mapping relationship is a mapping relationship between the compression mode and the type.

43. A communication apparatus, wherein the apparatus comprises:
a receiving unit, configured to receive compression information, wherein the compression information is determined based on indication information and first data, the indication information comprises types of a plurality of first regions in target space, the target space is determined based on a space boundary, and the first data is data in the target space.

44. The apparatus according to claim 43, wherein the compression information is obtained by compressing target data in a plurality of target regions based on the indication information, the first data, and a compression level, the compression level is one of N compression levels, an $M^{th}$ compression level represents compressing first data in first regions of M types, the $M^{th}$ compression level is one of the N compression levels, N is a positive integer, M is a positive integer not greater than N, and the plurality of target regions are the plurality of first regions in the target space.

45. The apparatus according to claim 44, wherein the compression information is obtained by compressing the target data in the plurality of target regions based on the indication information, the first data, the compression level, and a compression mode, and the compression mode comprises a subtree mode and a quantization mode.

46. The apparatus according to claim 44 or 45, wherein the plurality of target regions are regions that are in the plurality of first regions and that comprise the first data.

47. The apparatus according to any one of claims 43 to 46, wherein the indication information comprises an indication mode, the indication mode indicates a manner of the types of the plurality of first regions, and the indication mode comprises a grid mode and a space tree mode.

48. The apparatus according to claim 47, wherein the indication mode is determined based on a data feature of second data in the target space.

49. The apparatus according to claim 47, wherein the indication mode is determined based on a data feature of the first data in the target space.

50. The apparatus according to any one of claims 43 to 48, wherein the types of the plurality of first regions in the target space are determined based on a data feature of the second data in the plurality of first regions.

51. The apparatus according to any one of claims 43 to 47 or 49, wherein the types of the plurality of first regions in the target space are determined based on a data feature of the first data in the plurality of first regions.

52. The apparatus according to any one of claims 44 to 51, wherein the apparatus further comprises:
a sending unit, configured to send environment information, wherein the environment information represents location information of at least one piece of second data in the target space.

53. The apparatus according to claim 52, wherein the environment information comprises environment compression indication information and location compression information, and the location information is obtained by decompressing the location compression information based on the environment compression indication information.

54. The apparatus according to any one of claims 44 to 53, wherein the compression level is determined based on capacity information of a transmission resource.

55. The apparatus according to any one of claims 45 to 54, wherein the compression mode is determined based on a precision requirement of a base station for the target data and/or based on a data feature of the first data in the target region.

56. The apparatus according to any one of claims 45 to 54, wherein the compression mode is determined based on types of the plurality of target regions and a mapping relationship, and the mapping relationship is a mapping relationship between the compression mode and the type.

57. A communication apparatus, comprising a processor, a memory, an input interface, and an output interface, wherein the input interface is configured to receive information from a communication apparatus other than the communication apparatus, the output interface is configured to output information to a communication apparatus other than the communication apparatus, and when a computer program stored in the memory is invoked by the processor,

the method according to any one of claims 1 to 14 is implemented; or
the method according to any one of claims 15 to 28 is implemented.

58. A computer-readable storage medium, wherein the computer-readable storage medium stores a computer program or computer instructions, and when the computer program or the computer instructions are executed by a processor,

the method according to any one of claims 1 to 14 is implemented; or
the method according to any one of claims 15 to 28 is implemented.

59. A chip system, comprising at least one processor, a memory, and an interface circuit, wherein the memory, the interface circuit, and the at least one processor are interconnected through a line, the at least one memory stores instructions, and when the instructions are executed by the processor,

the method according to any one of claims 1 to 14 is implemented; or
the method according to any one of claims 15 to 28 is implemented.

60. A communication system, comprising the apparatus according to claims 29 to 42, and comprising the apparatus according to any one of claims 43 to 56.

Base station

Terminal
device 1

Terminal
device 2

FIG. 1

| Terminal device | | Base station |
|---|---|---|

S201: Determine compression
information based on indication
information and first data, where
the indication information
includes types of a plurality of
first regions in target space

S202: Send the compression information

FIG. 2

(X1, Y2, Z2)           (X2, Y2, Z2)

(X1, Y1, Z2)           (X2, Y1, Z2)

(X1, Y2, Z1)

(X2, Y2, Z1)

(X1, Y1, Z1)           (X2, Y1, Z1)

FIG. 3

(X1, Y2, Z2)           (X2, Y2, Z2)

(X1, Y1, Z2)           (X2, Y1, Z2)

(X1, Y2, Z1)

(X2, Y2, Z1)

(X1, Y1, Z1)           (X2, Y1, Z1)

FIG. 4

Type of a
first region:

| a | c | b | ... | a | b |

Indication
data stream:

| 0 | 2 | 1 | ... | 0 | 1 |

64 pieces
of data

FIG. 5

Root

1  0  0  0  0  0  1  0 — — — — — — — First
   a  a  a  a  a     a              layer

0  0  0  1  0  0  0  2  1  0  2  0  2  0  0  0 — — — Second
a  a  a  b  a  a  a  c  b  a  c  a  c  a  a  a       layer

FIG. 6

Terminal device

Base station

S701: Send environment information, where the environment information represents location information of at least one piece of second data in target space

S702: Remove first data that is in first data and that is within a preset range of the location information to obtain target data

S703: Determine compression information based on indication information and the first data, where the indication information includes types of a plurality of first regions in the target space

S704: Send the compression information

FIG. 7

FIG. 8

FIG. 9

FIG. 10

FIG. 11

## INTERNATIONAL SEARCH REPORT

| International application No. |
| --- |
| **PCT/CN2022/134525** |

**A. CLASSIFICATION OF SUBJECT MATTER**

H04L67/12(2022.01)i; G08G1/01(2006.01)i; H04N7/15(2006.01)i

According to International Patent Classification (IPC) or to both national classification and IPC

**B. FIELDS SEARCHED**

Minimum documentation searched (classification system followed by classification symbols)

IPC: H04L, G08G, H04N

Documentation searched other than minimum documentation to the extent that such documents are included in the fields searched

Electronic data base consulted during the international search (name of data base and, where practicable, search terms used)

CNTXT, ENTXTC, CNKI, VEN, ENTXT: 数据, 压缩, 缩放, 编码, 程度, 等级, 级别, 不同, 区域, 类型, 空间, data, compress+, encod+, degree, level, different, area, type, spatial

**C. DOCUMENTS CONSIDERED TO BE RELEVANT**

| Category* | Citation of document, with indication, where appropriate, of the relevant passages | Relevant to claim No. |
| --- | --- | --- |
| X | CN 114450733 A (PANASONIC INTELLECTUAL PROPERTY MANAGEMENT CO., LTD.) 06 May 2022 (2022-05-06)<br>description, paragraphs [0079]-[0117] | 1, 5-15, 19-29, 33-43, 47-60 |
| X | CN 114727083 A (CHINA MOBILE COMMUNICATIONS CORPORATION RESEARCH INSTITUTE et al.) 08 July 2022 (2022-07-08)<br>description, paragraphs [0093]-[0138] | 1, 5-15, 19-29, 33-43, 47-60 |
| X | CN 113870271 A (BEIJING YOUZHUJU NETWORK TECHNOLOGY CO., LTD.) 31 December 2021 (2021-12-31)<br>description, paragraphs [0029]-[0082] | 1, 5-15, 19-29, 33-43, 47-60 |
| A | CN 114693696 A (HUAWEI TECHNOLOGIES CO., LTD.) 01 July 2022 (2022-07-01)<br>entire document | 1-60 |
| A | JP 2018136890 A (TOYOTA MAPMASTER INC.) 30 August 2018 (2018-08-30)<br>entire document | 1-60 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **04 August 2023** | **04 August 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2022/134525**

| Patent document cited in search report | | | Publication date (day/month/year) | Patent family member(s) | | | Publication date (day/month/year) |
|---|---|---|---|---|---|---|---|
| CN | 114450733 | A | 06 May 2022 | EP | 4131203 | A1 | 08 February 2023 |
| | | | | JPWO | 2021200004 | A1 | 07 October 2021 |
| | | | | US | 2022198810 | A1 | 23 June 2022 |
| | | | | WO | 2021200004 | A1 | 07 October 2021 |
| CN | 114727083 | A | 08 July 2022 | None | | | |
| CN | 113870271 | A | 31 December 2021 | None | | | |
| CN | 114693696 | A | 01 July 2022 | None | | | |
| JP | 2018136890 | A | 30 August 2018 | JP | 6716480 | B2 | 01 July 2020 |

Form PCT/ISA/210 (patent family annex) (July 2022)